# EUROPÄISCHE PATENTSCHRIFT

(11) **EP 3 083 792 B1**
(45) Veröffentlichungstag und Bekanntmachung des Hinweises auf die Patenterteilung: **30.01.2019**
(21) Anmeldenummer: 14812517.2
(22) Anmeldetag: 16.12.2014
(51) Int. Cl.: C08K 3/24, C08K 3/22, C08L 77/00, H05K 3/18, C08K 7/14

(54) **KUNSTSTOFFFORMMASSE UND DEREN VERWENDUNG**
PLASTIC MOULDING MATERIAL AND USE OF SAME
MASSE DE MOULAGE EN MATIÈRE SYNTHÉTIQUE ET SON UTILISATION

(30) Priorität: 20.12.2013 EP 13199146
(43) Veröffentlichungstag der Anmeldung: 26.10.2016
(73) Patentinhaber: EMS-Patent AG, 7013 Domat/Ems (CH)
(72) Erfinder: STÖPPELMANN, Georg, CH-7402 Bonaduz (CH)
(74) Vertreter: Bremi, Tobias Hans
(86) Internationale Anmeldenummer: PCT/EP2014/077910
(87) Internationale Veröffentlichungsnummer: WO 2015/091447

(56) Entgegenhaltungen:
- EP-A1- 2 703 435
- EP-A1- 3 072 916
- EP-A2- 1 561 775
- WO-A1-2012/128219
- DE-A1-102006 015 508

## Beschreibung

### TECHNISCHES GEBIET

Die vorliegende Erfindung betrifft Formteile, hergestellt durch Extrusion von thermoplastischen Kunststoffformmassen, die neben Kunststoff LDS-Additive enthalten. Die extrudierten Formteile, insbesondere Folien, Profile und Hohlkörper sind nach partieller Bestrahlung gezielt metallisierbar. Des Weiteren betrifft die vorliegende Erfindung Verfahren zur Verwendung solcher extrudierter Formteile beispielsweise in Form von ein- oder mehrschichtigen Folien. Verwendung finden die erfindungsgemässen Formmassen insbesondere für die Herstellung von spritzgegossenen und extrudierten, metallisierbaren oder metallisierten Bauteilen.

### STAND DER TECHNIK

Moulded Intercontect Devices (MID) - Schaltungsträger aus thermoplastischen Kunststoffen in Spritzgiesstechnik - haben gegenüber bisherigen Schaltungsträgern den Vorteil der verbesserten Gestaltungsfreiheit, der guten Umweltverträglichkeit und des Rationalisierungspotentials bezüglich des Herstellverfahrens des Endproduktes. Die Integration von elektrischen und mechanischen Funktionen in ein Spritzgussteil kann zu einer Miniaturisierung der Baugruppe führen. Ausserdem können ganz neue Funktionen realisiert und nahezu beliebige Formen gestaltet werden. 2-Komponenten-Spritzgiessen, Heissprägen und Laser-Subtraktiv-Strukturieren sind bereits seit einigen Jahren in der Serienfertigung eingesetzte MID-Fertigungstechnologien.

Aus EP-A-1 274 288 ebenfalls bekannt ist die additive Laser-Strukturierungstechnik, bei welcher das im Standard-Spritzgiessverfahren hergestellte Formteil durch einen Laser strukturiert wird. Hierdurch werden auf der Kunststoffoberfläche partiell diejenigen Bereiche, die später die Leitungsbahnen tragen sollen, mit Metallatomen bekeimt, auf denen nachfolgend in chemisch reduktiven Metallisierungsbädern eine Metallschicht wächst. Die Metallkeime entstehen durch Aufbrechen von feinstverteilt im Trägermaterial enthaltenen Metallverbindungen.

WO2013/076314 beschreibt laserdirektstrukturierbare thermoplastische Formmassen, die ein auf Zinn basierendes Metallmischoxid als LDS-Additiv enthalten und zeigt anhand von unverstärkten spritzgegossenen Formmassen aus Polycarbonat oder Polycarbonat-ABS-Mischungen, dass diese Formmassen einen guten Weissgrad besitzen und dass die Metallisierung mit steigendem Anteil an Antimonoxid verbessert werden kann.

DE 101 53 922 A1 beschreibt ein Verfahren zur Herstellung eines spritzgegossenen Schaltungsträgers, bei dem eine strukturierte, nicht metallisierbare Folie, in der die geplanten Leiterbahnen ausgenommen sind, mit einem metallisierbaren Kunststoff hinterspritzt und anschliessend in den in der ursprünglichen Folie ausgenommenen und deswegen nun im metallisierbaren Kunststoff freiliegenden Bereichen, wo die Leiterbahnen entstehen sollen, der hinterspritzte Kunststoff metallisiert wird.

DE 40 36 592 A1 beansprucht spritzgegossene Leiterbahnen, die durch Hinterspritzen von flexiblen Schaltungen mit Thermoplasten erhalten wurden. Um die flexiblen Trägerfolien ausschliesslich an den geplanten Stellen, wo die Leiter entstehen sollen, metallisierbar zu machen, werden diese mit einer Siebdruckpaste, welche einen Metallisierungsaktivator enthält, lokal behandelt. Die mit fertigen Leiterbahnen versehene Trägerfolie wird dann mit einem thermoplastischen Kunststoff hinterspritzt, um zum gewünschten dreidimensionalen Schaltungsträger zu gelangen.

DE 10 2011 014 902 B3 betrifft ein Verfahren zur Herstellung eines Antennenbauelementes mit einer dreidimensionalen Antenne. Die Antenne, eine definierte durch Auftragen eines elektrisch leitfähigen Lackes erzeugte Leiterbahn, befindet sich auf einer thermoplastischen Trägerfolie, die durch Thermoformen in einem oder mehreren Biegebereichen in gewünschter Weise verbogen wird.

EP 1 987 707 A2 stellt ein Verfahren zur Erzeugung einer elektrisch leitfähigen Schicht auf einem Formkörper vor, bei dem eine umformbare Folie aus thermoplastischen Kunststoffen zunächst mit galvanisch katalytisch wirksamen Keimen dort, wo die Leiterbahnen entstehen sollen, versehen wird, so dann durch Tiefziehen in einen dreidimensionalen Formkörper umgeformt und in einem letzten Schritt metallisiert wird. DE 10 2006 015 508 beschreibt mehrschichtige, uniaxial gestreckte thermoplastische Polyesterfolien bestehend aus einer Basisschicht und mindestens einer Deckschicht, die 0.5-15 Gewichtsprozent einer durch elektromagnetische Strahlung aktivierbaren Metallverbindung enthalten. Gearbeitet werden nur reine Polyesterschichten, auf die Beimischung von anderen Polymeren wird hingewiesen, wobei aber eine Obergrenze von deren Anteil von 45 Gewichtsprozent festgelegt wird.

EP 1 561 775 beschreibt ebenfalls uniaxial gestreckte thermoplastische Polymerfolien mit 0.5-15 Gewichtsprozent einer durch elektromagnetische Strahlung aktivierbaren Metallverbindung. Gearbeitet werden ausschliesslich Systeme mit einem Polyamid-Anteil von höchstens 18 Gewichtsprozent.

WO2012128219 beschreibt ein thermoplastisches Harz-Formteil, welches gute Biegefestigkeit, hohes Biegeelastizitätsmodul und gute Charpy-Schlagzähigkeit aufweist, und auf der Oberfläche dessen eine LDS Metallisierung ausgebildet werden kann.

Die nachpublizierte EP-A-2 703 435 beschreibt eine thermoplastische Formmasse, insbesondere Polyamid-Formmasse bestehend aus: (A) 20 - 88 Gew.-% thermoplastischem Kunststoff; (B) 10 - 60 Gew.-% faserförmigen Zuschlagstoffen, aufgebaut aus (B1) 10 - 60 Gew.-% Glasfasern, ausgewählt aus der Gruppe bestehend aus: Glasfasern (B1_1) mit nicht-kreisförmigem Querschnitt, wobei das Achsenverhältnis der Hauptquerschnittsachse zur Nebenquerschnittsachse wenigstens 2 ist; hochfeste Glasfasern (B1_2) mit einer Glaszusammensetzung, die im Wesentlichen aus den Komponenten Siliciumdioxid, Aluminiumoxid und Magnesiumoxid aufgebaut sind; oder Mischungen davon; (B2) 0 - 20 Gew.-% von den Glasfasern der Komponente (B1) verschiedene Glasfasern mit kreisförmigem Querschnitt; (B3) 0 - 20 Gew.-% weitere, von den Fasern der Komponenten (B1) und (B2) verschiedene faserförmige, nicht auf Glas basierende Zuschlagstoffe ausgewählt aus der Gruppe: Kohlenstoffasern, Graphitfasern, Aramidfasern, Nanotubes; (C) 2 - 10 Gew.-% LDS-Additiv oder eine Mischung von LDS-Additiven; (D) 0 - 30 Gew.-% partikulärer Füllstoff; (E) 0 - 2 Gew.-% weitere andere Additive; wobei die Summe aus (A) - (E) 100 Gew.-% ausmacht.

Die ebenfalls nachpublizierte EP-A-3 072 916 beschreibt ein Verfahren zur Herstellung eines Polyamid- oder Polyesterformteils, Verfahren zur Herstellung von Formteilen mit hoher mechanischer Festigkeit und geringen Abschirmungseigenschaften, die direkt auf ihre Oberflächen aufplattiert werden können, und ein Formteil mit einer durch das Verfahren erhaltenen plattierten Schicht. Das Verfahren zur Herstellung eines Formteils umfasst das thermische Formen einer Folie, die ein thermoplastisches Harz und eine Faser enthält, zusammen mit einer Zusammensetzung, die ein thermoplastisches Harz eines ähnlichen Typs wie das thermoplastische Harz der Folie und ein LDS-Additiv enthält.

### DARSTELLUNG DER ERFINDUNG

Die thermischen und mechanischen Eigenschaften sowie die damit verbundenen Einsatzgebiete dieser bekannten MID Schaltungsträger werden in erster Linie durch die zugrundeliegende thermoplastische Formmasse bestimmt. Polyamide als Formmasse sind heutzutage weit verbreitet als Strukturelemente für den Innen- und Aussenbereich, was im Wesentlichen auf die hervorragenden mechanischen Eigenschaften zurückzuführen ist. Die laserdirektstrukturierbaren Formmassen enthalten sogenannte Laseradditive, die bei Einwirkung von elektromagnetischen Strahlen Metalle freisetzen. Für diese laserinduzierte Bekeimung kommen häufig Metalloxide, insbesondere Spinelle zum Einsatz. Zur Erhöhung der Mikrorauhigkeit und damit der Haftung der später aufgetragenen Leiterbahn können solche Formmassen zusätzlich noch beträchtliche Mengen an weiteren Füllstoffen enthalten, wie z.B. Talk. Durch den Zusatz von partikulären Füllstoffen oder Weisspigmenten zu den Formmassen werden die mechanischen Eigenschaften und die Extrusioneigenschaften aber in der Regel deutlich verschlechtert, insbesondere wird die Reissfestigkeit, die Reissdehnung sowie die Schlagzähigkeit reduziert.

Bei den üblichen Vorgehensweisen in der MID-Technologie unter Verwendung der Laserstrukturierung (LDS) wird also zur Erzeugung der Leiterbahnen in einem ersten Schritt (zweiter Schritt ist dann die nachgeschaltete stromlose Abscheidung der eigentlichen Leiter) also immer so vorgegangen, dass ein Bauteil aus einem Material, das als Ganzes in der Masse spezielle laseraktivierbare Metallverbindungen enthält, gespritzt wird. Obwohl diese Metallverbindungen ihrer Funktion entsprechend lediglich in der obersten Schicht des Schaltungsträgers zwingend vorhanden sein müssten, sind sie damit im gesamten Förmkörper verteilt und beeinträchtigen zudem die Materialeigenschaften z.T. beträchtlich.

Alle anderen oben erwähnten Methoden des Standes der Technik, um Leiterbahnen auszubilden, beruhen stets darauf, dass zunächst die Topologie der Leiter beispielsweise auf einer Folie vorgegeben wird, entweder durch schneiden der Folie, durch bedrucken der Folie oder ähnliches, anschliessend wird diese Folie hinterspritzt oder umgeformt. In diesem Verfahren wird also stets auf dem Halbzeug bereits die Topologie der Leiter vorgegeben, und anschliessend das Halbzeug zum Bauteil weiterverarbeitet. Nachteilig hierbei ist insbesondere, dass bei der Verarbeitung des Halbzeugs sichergestellt werden muss, dass die Topologie exakt aufrechterhalten bleibt, was nicht immer möglich ist.

Die vorliegende Erfindung geht einen völlig neuen Weg.

Ausgehend hiervon war es Aufgabe der vorliegenden Erfindung, geeignete thermoplastische Polyamidformmassen, und insbesondere solche, die laserdirektstrukturierbar sind, bereitzustellen, mit denen extrudierte Formkörper, insbesondere Folien oder Mehrschichtfolien mit guten mechanischen Eigenschaften, insbesondere mit hoher Flexibilität, hoher Reissfestigkeit und hoher Reissdehnung sowie guter Zähigkeit, herstellbar sind. Darüber hinaus sollen die Formkörper, Folien und mit Folien beschichteten Formkörper nach Laserbestrahlung gut metallisierbar sein und die Leiterbahnen sollen eine gute Haftung am thermoplastischen Substrat, insbesondere am Polyamidsubstrat aufweisen. Die Bereitstellung von flexiblen, mit Leiterbahnen am endgültigen Bauteil und nicht bereits am Halbzeug ausstattbaren Folien sowie die Bereitstellung von ein- und mehrschichtigen Leiterbahnen tragenden Folien als fertiges Bauteil erweitert die MID- zur EID (Extruded Interconnect Device)-Technologie. Die erfindungsgemässen Folien können auch mit thermoplastischen Kunststoffen hinterspritzt werden. Zudem sollen aus dem Material hergestellte Folien, insbesondere bei bevorzugten Ausführungsformen, eine gute Planarität aufweisen, dies nicht nur nach der Herstellung, sondern auch nach Laserstrukturierung und/oder nach Metallisierung.

Die vorliegende Erfindung umfasst damit einerseits ein Verfahren zur Herstellung eines laserstrukturierbaren Bauteils, beispielsweise einer Leiterplatte, eines Gehäuses für ein elektronisches Gerät, etc., andererseits derartig hergestellte Bauteile, sowie Formteile mit einem LDS-Additiv die insbesondere zur Herstellung solcher Bauteile besonders geeignet sind.

Der Kern der Erfindung besteht dabei u.a. darin, dass gefunden wurde, dass es unerwartet einfach möglich ist, die Eigenschaften, dass ein Bauteil laserstrukturierbar ist, nur in der oberflächlichen Schicht anzuordnen und damit einerseits durch die für die Laser-Strukturierbarkeit erforderlichen Modifikationen des Materials, konkret die Anwesenheit des LDS-Additivs, bedingten Nachteile der Materialeigenschaften für das ganze Bauteil weitgehend auszuschalten, diese Zusätze auch nur gerade im erforderlichen Umfang und in der erforderlichen Menge einzusetzen, namentlich nur gerade in der erforderlichen Oberflächenregion, und trotzdem eine hervorragende Haftung zwischen den am Ende ausgebildeten Leiterbahnen und dem Träger zur Verfügung zu stellen.

Gegenstand der vorliegenden Erfindung ist damit einerseits ein Verfahren zur Herstellung eines laserstrukturierbaren Bauteils nach Anspruch 1, welches Verfahren dadurch gekennzeichnet ist, dass ein extrudiertes, ein- oder mehrschichtiges Formteil mit mindestens einer, eine freiliegende Oberfläche des Formteils bildenden laserstrukturierbaren Schicht auf ein nicht laserstrukturierbares Trägerelement oberflächlich aufgebracht wird (oder extrudiert wird und dann vorgelegt und aufgebracht wird), oder mit einem nicht laserstrukturierbaren thermoplastischen Trägerelement hinterspritzt wird, so dass wenigstens eine laserstrukturierbare Schicht des Formteils vorzugsweise ohne bereits Leiterbahnen vorgebildet zu haben wenigstens einen Teil der Oberfläche des laserstrukturierbaren Bauteils bildet, oder dass das extrudierte, ein- oder mehrschichtige Formteil zum Bauteil tiefgezogen wird vorzugsweise ohne bereits Leiterbahnen vorgebildet zu haben (oder extrudiert wird und dann vorgelegt und tiefgezogen wird). Dabei besteht die laserstrukturierbare Schicht des Formteils im wesentlichen vollflächig aus einer thermoplastischen Formmasse aus:
(A) 30 - 99.9 Gew.-% thermoplastischem Kunststoff bestehend aus Polyamid (A1) oder aus einer Mischung aus einem Polyamid (A1) und einem anderen thermoplastischen Kunststoff (A2), wobei der Anteil an Polyamid (A1) wenigstens 70 Gew.-% bezogen auf die Summe aus (A1) und (A2) ausmacht;
(B) 0.1 - 10 Gew.-% LDS-Additiv
(C) 0 - 60 Gew.-% Zuschlagsstoffe verschieden von (A) und (B);
   wobei die Summe aus (A) - (C) 100 Gew.-% ausmacht.

(A1) besteht dabei, aber nur für den Fall der Anwesenheit von (A1) und (A2), aus einem teilaromatischen amorphen Polyamid (A1_3);
oder (A1) besteht generell aus einem cycloaliphatischen amorphen Polyamid (A1_4); oder aus einer Mischung aus aliphatischen Polyamiden (A1_1) und teilaromatischen, teilkristallinen Polyamiden (A1_2), amorphen teilaromatischen Polyamiden (A1_3) und/oder amorphen cycloaliphatischen Polyamiden (A1_4).

Bevorzugtermassen ist die laserstrukturierte Schicht dabei unverstreckt und/oder auch nicht thermofixiert, d.h. sie ist bevorzugter Massen das Resultat eines Extrusionsprozesses, Giessprozesses oder Beschichtungsprozesses ohne anschliessende Verstreckung, sei es uniaxial oder multiaxial oder Wärmebehandlung beispielsweise bei einer Temperatur von 200-250 °C. Weiterhin vorzugsweise ist der thermoplastische Kunststoff (A) frei von Polyester-Bestandteilen.

Bei der erfindungsgemässen, thermoplastischen Kunststoffformmasse wird durch Aufschmelzen bei Temperaturen über dem Schmelzpunkt oder oberhalb der Glasübergangstemperatur der thermoplastische Schmelzzustand erreicht. Die zähflüssige Schmelze wird meist auf Schneckenmaschinen (Extruder) in einer Art Giessprozess geformt. Beim Extrudieren wird die Schmelze kontinuierlich durch Profildüsen (Werkzeuge) zu Halbzeugen verarbeitet. Beim Spritzgießen als diskontinuierlichem Verfahren wird die Schmelze unter hohem Druck in das geschlossene Werkzeug schnell eingebracht, dabei entstehen spritzgegossene Formteile. Der Unterschied zwischen den beiden Verarbeitungsverfahren ist, dass beim Spritzgiessen ein Fertigprodukt resultiert, während beim Extrudieren nur Halbzeuge entstehen. Des Weitern ist das Spritzgiessen ein diskontinuierliches Verfahren, bei dem die Förderschraube als Kolben wirkt, was beim Extrudieren nicht der Fall ist. Aufgrund dieser Unterschiede hat die Extrusion gegenüber dem Spritzguss in Bezug auf das gefertigte Formteil einige Vorteile, denn die extrusionsgefertigten Formteile verfügen über andere Materialeigenschaften als die spritzgegossenen Formteile, dies namentlich hinsichtlich Spannungsfreiheit, Verzug, Planität, Reckbarkeit, Verstreckbarkeit, Flexibilität, Biegeradien, minimale Wandstärke etc. spezifischer z.B.:
- Extrudierte Formteile sind spannungsfreie Formteile, mit keinem oder geringem Verzug und hoher Planität;
- Extrudierte Formteile können als dünne Teile, insbesondere dünne, grossflächige Teile ausgebildet sein;
- Extrudierte Folien sind reck- und verstreckbar;
- Extrudierte Formteile, insbesondere Folien, haben eine hohe Flexibilität und lassen kleine Biegeradien zu
- Extrudierte Rohrabschnitte oder Profile haben keine Entformungsschrägen
- Extrusion stellt lange, bindenahtlose Profile und Rohre, insbesondere mit mehreren Schichten oder geringen Wandstärken der Schichten zur Verfügung.

Eine bevorzugte Ausführungsform des Verfahrens kennzeichnet sich dadurch, dass es sich beim Formteil um ein Profil, ein Rohr, einen Film oder eine Folie handelt, vorzugsweise um einen Film oder eine Folie, wobei diese Formteile mindestens eine erfindungsgemässe laserstrukturierbare Schicht aufweisen, welche bei einschichtiger Bauweise des Formteils das Formteil als Ganzes allein bildet, und diese Schicht, vorzugsweise eine Dicke im Bereich von 10 - 1000 Micrometer, vorzugsweise im Bereich von 20 - 600, insbesondere 30 - 400 oder 40 - 300 Micrometer aufweist und wobei weiterhin vorzugsweise der Film respektive die Folie durch die laserstrukturierbare Schicht allein gebildet wird oder eine oder mehrere von der laserstrukturierbaren Schicht verschiedene Trägerschichten aufweist, auf denen Film respektive Folie auf einer oder beiden Seiten, die Oberfläche bildend, angeordnet sind.

Eine bevorzugte Ausführungsform betrifft einen mindestens zwei Schichten, insbesondere bevorzugt genau zwei Schichten umfassenden Formkörper, wobei der Formkörper als Rohr, Profil oder Folie ausgebildet sein kann und neben der laserstrukturierbaren Schicht (S) mehrere, vorzugsweise genau eine weitere Trägerschicht (T) vorhanden ist. Weiterhin ist bevorzugt, wenn das Dickenverhältnis von Schicht S zu Schicht T wenigstens 1:2, vorzugt von wenigstens 1:10 beträgt, bevorzugt im Bereich von 1:2 bis 1:100 oder 1:1000 liegt. Hierbei ist es vorteilhaft, wenn die Schicht S möglichst dünn ausgeführt wird, d.h. eine Dicke von bevorzugt 10-100 µm, besonders bevorzugt von 10-50 µm aufweist. Die Schicht T hat hierbei eine Dicke von 20-1000 µm, vorzugsweise von 50 - 500 µm. Damit eine sehr gute Laserstrukturierung und nachfolgende Metallisierung sowie ausreichende Haftung der stromlos aufgebrachten Metallschicht gewährleistet ist, wird bei dieser Ausführungsform des Formteils die Konzentration des LDS-Additivs in der Schicht S vorteilhaft auf ein höheres Niveau eingestellt, ohne insgesamt mehr LDS-Additiv für das gesamte Bauteil, umfassend mindestens eine Schicht S und mindestens eine Schicht T, einzusetzen. Bevorzugtermassen liegt der Anteil des LDS-Additivs (B) in der Schicht S bei wenigstens 2, bevorzugt wenigstens 4, insbesondere bevorzugt bei wenigstens 5 Gew.-% bezogen auf die gesamte Formmasse, welche die Schicht S bildet. Somit liegt der LDS-Additiv-Anteil in der Schicht S bevorzugt im Bereich von 4-10, insbesondere im Bereich von 5-10 Gew.-%.

Das Formteil kann auf unterschiedliche Weise auf das Trägerelement aufgebracht werden. So ist es möglich, dass Formteil auf die Oberfläche des Trägerelements aufzukleben (unter Verwendung eines Haftvermittlers), aufzulaminieren (mit oder ohne Haftvermittler), oder aufzukaschieren, jeweils vorzugsweise unter Anwendung von Druck und/oder Hitze, gegebenenfalls kann auch vernetzt werden.

Das Formteil oder die laserstrukturierbare Schicht (S) kann alternativ auch direkt aus dem schmelzflüssigen Zustand auf das Trägerelement (Trägerschicht (T)) in einer Coextrusion oder Mehrschichtextrusion mit oder ohne Zwischenschaltung einer Haftvermittlerschicht aufextrudiert werden, für Folien vorzugsweise unter Verwendung einer Schlitzdüse in Form eines zusammenhängenden Films auf der Oberfläche des Trägerelements. So kann in situ eine besonders gute Verbindung mit dem Trägerelement hergestellt werden, und es können beispielsweise auch Trägerelemente aus ganz anderen Materialien beschichtet werden, beispielsweise aus Duroplasten, oder grundsätzlich ganz anderen Materialien wie Holz, Textilien, Metallen, etc.

Das Formteil kann auch in einem in mould-Verfahren als Folie in einer Form vorgelegt werden und hinterspritzt werden, so dass sich dann das Trägerelement aus dem hinterspritzten Material ausbildet. Eine andere Ausführungsform beinhaltet also das Hinterspritzen der erfindungsgemässen Folie, umfassend die laserstrukturierbare Schicht mit einem thermoplastischen Kunststoff, wobei die Folie bereits Leiterbahnen auf mindestens einer Seite tragen oder in einem nachgelagerten Schritt oberflächlich mit Leiterbahnen versehen werden kann.

Wie gesagt ist es ebenfalls möglich, ohne Trägerelement zu arbeiten, und das Formteil als ganzes in die gewünschte Form zu bringen, beispielsweise in einem Umform- oder Tiefzieh-Prozess. Die laserstrukturierbare Schicht erhält dabei durch Umformen, insbesondere durch Tiefziehen eine dreidimensionale Struktur.

Das Trägerelement und/oder insbesondere das Formteil besteht dabei aus einem polyamidhaltigen Kunststoff. Bevorzugt sind Mischungen aus aliphatischen Polyamiden (A1_1) und amorphen Polyamiden (A1_2) oder Mischungen aus teilaromatischen, teilkristallinen Polyamiden mit amorphen Polyamiden.

In einem nachfolgenden Bearbeitungsschritt können dann gemäß einer weiteren bevorzugten Ausführungsform auf dem Bauteil bzw. auf der Schicht (S) durch Laser-Direktstrukturierung und anschließende stromlose und gegebenenfalls zusätzliche galvanische Abscheidung von Metallen Leiterbahnen auf dem Bauteil ausgebildet werden, sowie gegebenenfalls anschließend elektrische und/oder elektronische Komponenten eingebunden werden, sowie weitere Schritte folgen wie zum Beispiel Assembly etc..

Des Weiteren betrifft die vorliegende Erfindung entsprechend auch ein Bauteil hergestellt oder herstellbar nach einem Verfahren wie oben beschrieben, vorbereitet für oder mit elektrischen Leiterbahnen, bevorzugt als Trägerelement, Leiterplatte, Gehäuse oder Gehäuseteil für insbesondere tragbare elektronische Geräte, wie insbesondere PDAs, Mobiltelefone, Telekommunikations-Geräte, Trägerelemente, Leiterplatten, Gehäuse oder Gehäuseteile für Personal Computer, Notebooks, medizinische Geräte, wie insbesondere Hörgeräte, Sensortechnik, oder RFID Transponder oder Teile für den Automobilbereich, wie insbesondere Airbagmodul, Multifünktionslenkrad.

Die Bauteile sind also auf Basis eines extrudierten Formteils umfassend eine Schicht (S) hergestellt aus einer Formmasse wie weiter unten dargestellt, aufgebaut. Einsatzgebiete für solche Bauteile und die MID-Technologie sind der Automobilbau, die Industrieautomation, die Medizintechnik, die Hausgeräteindustrie, Unterhaltungselektronik, die Telekommunikationstechnik, die Mess- und Analysetechnik, Maschinenbau, sowie Luft- und Raumfahrt. Die Erfindung betrifft damit auch einen Artikel in Form von Bauteilen und Formkörpern, insbesondere einen Schaltungsträger, enthaltend ein Formteil umfassend die Schicht (S) aus der erfindungsgemässen Formmasse. In einer Ausführungsform wird der Schaltungsträger genutzt, um eine Antenne auszubilden.

Solche Formteile sind beispielsweise Gehäuse oder Gehäuseteile für tragbare elektronische, wie z.B. PDAs, Mobiltelefone, andere Telekommunikations-Geräte, flexible Mobiltelefone-Gehäuse oder Teile, Folien oder Teile für Dünnschichtbatterien, Gehäuse oder Gehäuseteile für Personal Computer, Notebooks, medizinische Geräte, wie z.B. Hörgeräte, Sensortechnik, oder RFID (Radio Frequency IDentification) Transponder oder Teile für den Automobilbereich, wie z.B. Airbagmodul, Multifunktionslenkrad oder aber auch metallisierte oder metallisierbare Folien zu Dekorzwecken.

Aufgrund der Materialeigenschaften können dreidimensionale Schaltungsträger realisiert werden. Darüber hinaus können typische mechanische Funktionen wie Halter, Führungen, Taster, Stecker oder andere Verbindungselemente integriert werden. Ebenfalls möglich sind Konnektoren für E/E und für Kraftstoffsysteme. Weiterhin betrifft die Erfindung Leiterbahnen oder Metallstrukturen tragende flexible Formkörper, insbesondere Folien, die im Gegensatz zu den spritzgegossenen Bauteilen eine hohe Flexibilität besitzen, sodass z.B. eine Folie, umfassend die Schicht (S), zu einer Rolle mit einem Durchmesser von weniger als 10 mm aufgerollt werden kann, also ein kleiner Biegeradius möglich ist, ohne dass sich die Leiterbahnen oder Metallstrukturen ablösen bzw. beschädigt werden.

Zudem betrifft die vorliegende Erfindung ein extrudiertes, ein- oder mehrschichtiges Formteil nach Anspruch 11, vorzugsweise zur Verwendung in einem Verfahren wie oben dargelegt respektive zur Verwendung in einem Bauteil wie oben dargelegt, oder ein Extrusionsverfahren zur Herstellung eines solchen Formteils, mit mindestens einer, eine freiliegende Oberfläche des Formteils bildenden laserstrukturierbaren Schicht (S), im wesentlichen vollflächig bestehend aus einer thermoplastischen Formmasse aus:
(A) 30 - 99.9 Gew.-% thermoplastischem Kunststoff, bestehend aus Polyamid (A1) oder aus einer Mischung aus einem Polyamid (A1) und einem anderen thermoplastischen Kunststoff (A2), wobei der Anteil an Polyamid (A1) wenigstens 70 Gew.-% bezogen auf die Summe aus (A1) und (A2) ausmacht, wobei (A1) ein teilaromatisches amorphes Polyamid (A1_3) oder ein cycloaliphatisches amorphes Polyamid (A1_4) ist oder eine Mischung aus aliphatischen Polyamiden (A1_1) und teilaromatischen, teilkristallinen Polyamiden (A1_2), amorphen teilaromatischen Polyamiden (A1_3) und/oder amorphen cycloaliphatischen Polyamiden (A1_4) ist;
(B) 0.1 - 10 Gew.-% LDS-Additiv
(C) 0 - 60 Gew.-% Zuschlagsstoffe verschieden von (A) und (B);
   wobei die Summe aus (A) - (C) 100 Gew.-% ausmacht, und wobei beim Verfahren eine solche Schicht in einem Extrusionsverfahren hergestellt wird.

Ein solches Formteil ist ein Film oder eine Folie, wobei Film respektive Folie eine Dicke im Bereich von 10 - 600 Micrometer, vorzugsweise im Bereich von 20 - 600 Micrometer, insbesondere im Bereich von 30 - 400 oder 40 - 300 aufweist und wobei vorzugsweise der Film respektive die Folie durch die laserstrukturierbare Schicht (S) allein gebildet wird oder eine oder mehrere von der laserstrukturierbaren Schicht verschiedene Trägerschichten (Schichten (Tᵢ)) aufweist, auf denen Film respektive Folie auf einer oder beiden Seiten, die Oberfläche bildend, angeordnet sind, wobei dann vorzugsweise diese Oberflächenschichten auf Trägerschicht eine Dicke im Bereich von 10-250 µm aufweisen, vorzugsweise im Bereich von 20-150 Mikrometer.

Nach einer weiteren bevorzugten Ausführungsform ist das Formteil dadurch gekennzeichnet, dass der thermoplastische Kunststoff der Komponente (A) wenigstens ein aliphatisches Polyamid in einer Konzentration von mindestens 40 Gew.-%, bevorzugt in einem Bereich von 50 - 95 Gew.-% in Bezug auf die Gesamtmenge an Komponente (A) enthält, und wobei weiterhin vorzugsweise das wenigstens eine aliphatische Polyamid der Komponente (A) ein CH₂/Amid-Verhältnis von ≥ 7 aufweist.

Die erfindungsgemässe Formmasse besteht hinsichtlich **Komponente (A)** aus 30 bis 99.9 Gew.-%, bevorzugt aus 42 bis 99 Gew.-%, besonders bevorzugt 44 bis 98 Gew.-% eines thermoplastischen Kunststoffs (A), wobei Komponente (A) zu wenigstens 70 Gew.-% oder 80 Gew.-% aus Polyamid (A1) besteht, der Rest wird durch einen anderen thermoplastischen Kunststoff (A2) gebildet.

Gemäss einer besonders bevorzugten Ausführungsform besteht Komponente (A) ausschliesslich aus Polyamid (A1).

Gemäss Erfindung kann Komponente (A) bestehen aus: neben anderen thermoplastischen Kunststoffen (A2) aus **Polyamiden (A1)** ausgewählt aus der Gruppe bestehend aus: aliphatischen Polyamiden (A1_1), teilaromatischen, teilkristallinen Polyamiden (Polyphthalamide und araliphatische Polyamide) (A1_2), teilaromatischen amorphen Polyamiden (A1_3) und/oder cycloaliphatischen amorphen Polyamiden (A1_4) in einer Konzentration von mindestens 40 Gew.-%, bevorzugt in einem Bereich von 50 - 100 Gew.-% in Bezug auf die Gesamtmenge an Komponente (A).

Bevorzugtermassen besteht Komponente (A) ausschliesslich aus den genannten Polyamiden (A1_1) bis (A1_4).

In einer weiteren Ausführungsform ist die Komponente (A1) bevorzugtermassen eine Mischung aus aliphatischen Polyamiden (A1_1) und amorphen Polyamiden (A1_3) und/oder (A1_4), wobei der Gehalt von Komponente (A1_1) im Bereich von 40 bis 95 Gew.-% und der Gehalt der Summe der Komponenten (A1_3) und/oder (A1_4) in einem Bereich von 5 - 60 Gew.-% in Bezug auf die Gesamtmenge an Komponente (A1) ausmacht.

Gemäss einer weiteren bevorzugten Ausführungsform besteht das Polyamid (A1) aus mindestens einem amorphen oder mikrokristallinen Polyamid auf Basis cycloaliphatischer Diamine (A1_4) und gegebenenfalls weiteren Polyamiden, bevorzugter Massen ausgewählt aus der Gruppe der teilkristallinen, aliphatischen Polyamide (A1_1) oder teilkristallinen, teilaromatischen Polyamiden (A1_2).

Weiterhin vorzugsweise besteht das Polyamid (A1) gemäss einer weiteren bevorzugten Ausführungsform aus 20 - 100 Gew.-%, bevorzugt 30-90 oder 35-80 Gew.-% aus amorphem cycloaliphatischem Polyamid (A1_4) und 0 - 80 Gew.-%, bevorzugt 10-70 oder 20-65 Gew.-% aliphatischem Polyamid (A1_1) und/oder teilkristallinem, teilaromatischem Polyamid (A1_2).

Die **Komponente (A2)** ist verschieden von (A1) und kann dabei ausgewählt sein aus der Gruppe bestehend aus: Polycarbonat, Polystyrol, Polymethylmethacrylat, AcrylnitrilButadien-Styrol-Copolymerisat, Acrylnitril-Styrol-Copolymer, Polyolefin, Polyoxymethylen, Polyester, insbesondere Polyethylenterephthalat, Polybutylenterephthalat, Polysulfon, insbesondere des Typs PSU, PESU, PPSU, Polyphenylenether, Polyphenylensulfid, Polyphenylenoxid, flüssigkristalline Polymere, Polyetherketon, Polyetheretherketon, Polyimid, Polyamidimid, Polyesterimid, Polyetheramid, Polyesteramid, Polyetheresteramid, Polyurethan, insbesondere des Typs TPU, PUR, Polysiloxan, Polyacrylat, Polymethacrylat sowie Mischungen oder Copolymere auf Basis solcher Systeme.

Als aliphatische Polyamide der **Komponente (A1_1)** werden rein aliphatische Polyamide bezeichnet, d.h. dieser Begriff schliesst cycloaliphatische Polyamide, wie sie im Rahmen von Komponente (A1_4) definiert werden, aus. Beim aliphatischen Polyamid der Komponente (A1_1) handelt es sich generell um ein Polyamid aufgebaut aus gesättigten linearen oder verzweigten Lactamen und/oder gesättigten linearen oder verzweigten Aminosäuren mit jeweils 6-12 Kohlenstoffatomen, und/oder aus gesättigten linearen oder verzweigten Dicarbonsäuren mit 6-18, bevorzugt mit 6-12 Kohlenstoffatomen und gesättigten linearen oder verzweigten Diaminen mit 4-12 Kohlenstoffatomen, respektive um Copolyamide aufgebaut aus diesen Bausteinen.

Bevorzugt handelt es sich bei den aliphatischen Polyamiden der Komponente (A1_1) um Polyamide ausgewählt aus der Gruppe: Polyamid 46, Polyamid 6, Polyamid 66, Polyamid 11, Polyamid 12, Polyamid 1212, Polyamid 1010, Polyamid 1012, Polyamid 1112, Polyamid 610, Polyamid 106, Polyamid 612, Polyamid 69, Polyamid 810 oder deren Copolyamide, Gemische, Blends oder Legierungen eingesetzt. Das aliphatische Polyamid (A1) besitzt dabei bevorzugt eine Lösungsviskosität ηᵣₑₗ, gemessen in m-Kresol (0,5 Gew.-%, 20 °C) im Bereich von 1.5 bis 3.0, bevorzugt im Bereich von 1.6 bis 2.6, insbesondere im Bereich von 1.7 bis 2.3.

Weiterhin ist bevorzugt, wenn das aliphatische Polyamid (A1_1) ein Methylen/Amid-Verhältnis von wenigstens 5 und insbesondere von wenigstens 7 aufweist, wobei das Verhältnis bevorzugt im Bereich von 5 bis 12, besonders bevorzugt im Bereich von 7 - 12 liegt. Insbesondere ist bevorzugt, dass die Komponente (A1_1) ausgewählt ist aus der Gruppe bestehend aus Polyamid PA610, PA106, PA1010, PA1012, PA 1212, PA11 oder PA12.

Bei der **Komponente (A1_2)** handelt es sich um teilkristalline, teilaromatische Polyamide, umfassend Polyphthalamide, welche auf Terephthalsäure beruhen und araliphatische Polyamide, welche auf Xylylendiamin (para- oder meta-) beruhen. Beispiele für araliphatische Polyamide sind MXD6-18 (MXD = meta-Xylylendiamin), wobei MXD6 und MXD10 bevorzugt werden.

Bevorzugt werden als A1_2 Polyphthalamide eingesetzt, welche bevorzugtermassen eine Glasübergangstemperatur im Bereich von 90 bis 140°C, bevorzugt im Bereich von 110 bis 140°C und insbesondere im Bereich von 115 bis 135°C besitzen. Der Schmelzpunkt des Polyamids (A1_2) liegt im Bereich von 255 bis 330°C, bevorzugt im Bereich von 270 bis 325°C und insbesondere im Bereich von 280 bis 320 °C. Bevorzugt verfügen die teilkristallinen, teilaromatischen Polyamide der Komponente über mittels DSC bestimmte Schmelzenthalpien (ISO-Norm 11357-11-2) im Bereich von 25 bis 80 J/g, vorzugsweise im Bereich von 30 bis 70 J/g.

Bevorzugte teilaromatische teilkristalline Polyamide sind dabei aus
a) 30 bis 100 mol-%, insbesondere 50 bis 100 mol-% Terephthalsäure und/oder Naphthalindicarbonsäure sowie 0 bis 70 mol-%, insbesondere 0 bis 50 mol-% mindestens einer aliphatischen Dicarbonsäure mit 6 bis 18, bevorzugt 6-12 Kohlenstoffatomen, und/oder 0 bis 70 mol-%, insbesondere 0 bis 50 mol-% mindestens einer cycloaliphatischen Dicarbonsäure mit 8 bis 20 Kohlenstoffatomen, und/oder 0 bis 50 mol-% Isophthalsäure, bezogen auf die Gesamtmenge der Dicarbonsäuren,
b) 80 bis 100 mol-% mindestens eines aliphatischen Diamins mit 4-18 Kohlenstoffatomen, vorzugsweise mit 6 bis 12 Kohlenstoffatomen sowie 0 bis 20 mol-% mindestens eines cycloaliphatischen Diamins, vorzugsweise mit 6 bis 20 Kohlenstoffatomen, wie z.B. PACM, MACM, IPDA und/oder 0 bis 20 mol-% mindestens eines araliphatischen Diamins, wie z.B. MXDA und PXDA, bezogen auf die Gesamtmenge der Diamine, sowie gegebenenfalls
c) Aminocarbonsäuren und/oder Lactamen je mit 6 bis 12 Kohlenstoffatomen, hergestellt. Gemäß einer bevorzugten Ausführungsform wird dabei das teilaromatische Polyamid der Komponente (A1_2) auf Basis von wenigstens 55 Mol-%, insbesondere von wenigstens 65 Mol-% Terephthalsäure und wenigstens 80 Mol-%, bevorzugt wenigstens 90 Mol-%, insbesondere wenigstens 95 Mol-% aliphatischen Diaminen mit 4 bis 18 Kohlenstoffatomen, vorzugsweise mit 6-12 Kohlenstoffatomen, und gegebenenfalls weiteren aliphatischen, cycloaliphatischen und aromatischen Dicarbonsäuren sowie Lactamen und/oder Aminocarbonsäuren, gebildet. Als weitere aromatische Dicarbonsäuren können neben der Terephthalsäure Isophthalsäure und Naphthalindicarbonsäure verwendet werden. Geeignete aliphatische und cycloaliphatische Dicarbonsäuren, die neben Terephthalsäure verwendet werden können, besitzen 6 bis 36 Kohlenstoffatome und werden in einem Anteil von höchstens 70 Mol-%, insbesondere in einem Anteil von höchstens 50 Mol-%, bezogen auf die Gesamtmenge der Dicarbonsäuren, eingesetzt. Zudem ist bevorzugt, dass die genannten aromatischen Dicarbonsäuren des teilaromatischen Polyamids der Komponente (A1_2) ausgewählt sind aus der Gruppe: Terephthalsäure, Isophthalsäure, sowie Mischungen davon.

Gemäß einer weiteren bevorzugten Ausführungsform sind die genannten z.B. aliphatischen Dicarbonsäuren des teilaromatischen Polyamids der Komponente (A1_2), die neben Terephthalsäure eingesetzt werden können, ausgewählt aus der Gruppe Adipinsäure, Korksäure, Azelainsäure, Sebazinsäure, Undecandisäure, Dodecandisäure, Brassylsäure,

Tetradecandisäure, Pentadecandisäure, Hexadecandisäure, Octadecandisäure und Dimerfettsäure (C36). Besonders bevorzugt werden Adipinsäure, Sebazinsäure und Dodecandisäure. Dicarbonsäuren die neben Terephthalsäure bevorzugt eingesetzt werden sind demnach: Isophthalsäure, Adipinsäure, Sebazinsäure und Dodecandisäure oder eine Mischung derartiger Dicarbonsäuren. Insbesondere wird werden Polyamide A1_2 bevorzugt, die ausschliesslich auf Terephthalsäure als Dicarbonsäure beruhen.

Gemäß einer weiteren bevorzugten Ausführungsform sind die genannten aliphatischen Diamine des teilaromatischen Polyamids der Komponente (A1_2) ausgewählt aus der Gruppe 1,4-Butandiamin, 1,5-Pentandiamin, 1,6-Hexandiamin, 1,7-Heptandiamin, 1,8-Octandiamin, 1,9-Nonandiamin, Methyl-1,8-Octandiamin, 1,10-Decandiamin, 1,11-Undecandiamin, 1,12-Dodecandiamin, oder einer Mischung derartiger Diamine, wobei 1,6-Hexandiamin, 1,10-Decandiamin, 1,12-Dodecandiamin, oder eine Mischung derartiger Diamine bevorzugt ist, wobei 1,6-Hexandiamin und 1,10-Decandiamin besonders bevorzugt sind. Neben den aliphatischen Diaminen können in einer Konzentration von 0 bis 20 Mol-%, bezogen auf die Gesamtmenge an Diaminen, cycloaliphatische und/oder araliphatische Diamine ersetzt werden. Besonders bevorzugt werden die hochschmelzenden Polyamide aus folgenden Komponenten gebildet:
a) (A1_2a) Dicarbonsäuren: 50 - 100 Mol-% aromatische Terephthalsäure und/oder Naphthalindicarbonsäure, bezogen auf den Gesamtgehalt an anwesenden Dicarbonsäuren, 0 - 50 Mol-% einer aliphatischen Dicarbonsäure, bevorzugt mit 6 bis 12 Kohlenstoffatomen, und/oder einer cycloaliphatischen Dicarbonsäure mit bevorzugt 8 bis 20 Kohlenstoffatomen, und/oder Isophthalsäure;
b) (A1_2b) Diamine: 80 - 100 Mol-% mindestens eines aliphatischen Diamins mit 4-18 Kohlenstoffatomen, vorzugsweise mit 6 bis 12 Kohlenstoffatomen, bezogen auf den Gesamtgehalt an anwesenden Diaminen, 0 - 20 Mol-% cycloaliphatische Diamine, vorzugsweise mit 6 bis 20 Kohlenstoffatomen, wie z.B. PACM, MACM, IP-DA und/oder araliphatische Diamine, wie z.B. MXDA und PXDA, wobei in den hochschmelzenden Polyamiden der prozentuale Molgehalt an Dicarbonsäuren 100 % und der prozentuale Molgehalt an Diaminen 100 % ausmacht, und gegebenenfalls aus:
c) (A1_2c) Aminocarbonsäuren und/oder Lactamen, enthaltend Lactame mit bevorzugt 6 bis 12 Kohlenstoffatomen, und/oder Aminocarbonsäuren mit bevorzugt 6 bis 12 Kohlenstoffatomen.

Während die Komponenten (A1_2a) und (A1_2b) weitgehend äquimolar eingesetzt werden, beträgt die Konzentration von (A1_2c) vorzugsweise höchstens 20 Gew.-%, bevorzugt höchstens 15 Gew.-%, insbesondere höchstens 12 Gew.-%, jeweils bezogen auf die Summe von (A1_2a) bis (A1_2c).

Zusätzlich zu den weitgehend äquimolar eingesetzten Komponenten (A1_2a) und (A1_2b) können Dicarbonsäuren (A1_2a) oder Diamine (A1_2b) zur Regelung der Molmasse oder zum Ausgleich von Monomerverlusten bei der Polyamidherstellung eingesetzt werden, sodass in ihrer Gesamtheit die Konzentration einer Komponente (A1_2a) oder (A1_2b) überwiegen kann.

Geeignete cycloaliphatische Dicarbonsäuren sind die cis- und/oder trans-Cyclohexan-1,4-dicarbonsäure und/oder cis- und/oder trans-Cyclohexan-1,3-dicarbonsäure (CHDA).

Die oben genannten, in der Regel eingesetzten aliphatischen Diamine können in untergeordneter Menge von nicht mehr als 20 Mol-%, von vorzugsweise nicht mehr als 15 Mol-% und insbesondere nicht mehr als 10 Mol-%, bezogen auf die Gesamtmenge der Diamine, durch andere Diamine ersetzt werden. Als cycloaliphatische Diamine können beispielsweise Cyclohexandiamin, 1,3-Bis-(aminomethyl)-cyclohexan (BAC), Isophorondiamin, Norbornandimethylamin, 4,4'-Diaminodicyclohexylmethan (PACM), 2,2-(4,4'-Diaminodicyclohexyl)propan (PACP) und 3,3'-Dimethyl-4,4'-diaminodicyclohexylmethan (MACM) verwendet werden. Als araliphatische Diamine seien m-Xylylendiamin (MXDA) und p-Xylylendiamin (PXDA) erwähnt.

Zusätzlich zu den beschriebenen Dicarbonsäuren und Diaminen können noch Lactame und/oder Aminocarbonsäuren als polyamidbildende Komponenten (Komponente (A1c)) eingesetzt werden. Geeignete Verbindungen sind beispielsweise Caprolactam (CL), α,ω-Aminocapronsäure, α,ω-Aminononansäure, α,ω-Aminoundecansäure (AUA), Laurinlactam (LL) und α,ω-Aminododecansäure (ADA). Die Konzentration der zusammen mit den Komponenten (A1_2a) und (A1_2b) eingesetzten Aminocarbonsäuren und/oder Lactame beträgt höchstens 20 Gew.-%, bevorzugt höchstens 15 Gew.-% und besonders bevorzugt höchstens 12 Gew.-%, bezogen auf die Summe der Komponenten (A1_2a) bis (A1_2c). Speziell bevorzugt sind Lactame bzw. α,ω-Aminosäuren mit 4, 6, 7, 8, 11 oder 12 C-Atomen. Dies sind die Lactame Pyrrolidin-2-on (4 C-Atome), ε-Caprolactam (6 C-Atome), Önanthlactam (7 C-Atome), Capryllactam (8 C-Atome), Laurinlactam (12 C-Atome) bzw. die α,ω-Aminosäuren 1,4-Aminobutansäure, 1,6-Aminohexansäure, 1,7-Aminoheptansäure, 1,8-Aminooctansäure, 1,11-Aminoundecansäure und 1,12-Aminododecansäure. In einer besonders bevorzugten Ausführungsform ist Komponente A1_1 frei von Caprolactam bzw. Aminocapronsäure.

Zur Regelung der Molmasse, der relativen Viskosität bzw. der Fliessfähigkeit oder des MVR können dem Ansatz und/oder dem Vorkondensat (vor der Nachkondensation) Regler in Form von Monocarbonsäuren oder Monoaminen zugesetzt werden.

Konkrete Vertreter für die erfindungsgemäßen Polyamide (A1_2) sind: PA 4T/4I, PA 4T/6I, PA 5T/5I, PA 6T/6, PA 6T/6I, PA 6T/6I/6, PA 6T/66, 6T/610, 6T/612, PA 6T/10T, PA 6T/10I, PA 9T, PA 10T, PA 12T, PA 10T/10I, PA10T/106, PA10T/12, PA10T/11, PA 6T/9T, PA 6T/12T, PA 6T/10T/6I, PA 6T/6I/6, PA 6T/6I/12 sowie Mischungen davon, insbesondere vorzugsweise ist das teilaromatische Polyamid der Komponente (A1_2) ausgewählt aus der Gruppe: PA 6T/6I, PA 6T/10T, PA 6T/10T/6I, sowie Mischungen davon. Bevorzugt werden Polyamide (A1_1), welche 6T-Einheiten, insbesondere wenigstens 10 Gew.-% an 6T-Einheiten enthalten.

Das teilaromatische, teilkristalline Polyamid (A1_2) hat eine Lösungsviskosität ηᵣₑₗ, (bestimmt nach DIN EN ISO 307, 0.5 Gew.-% in m-Kresol, 20 °C) von höchstens 2,6, bevorzugt von höchstens 2,3, insbesondere von höchstens 2,0. Bevorzugt werden Polyamide (A1) mit einer Lösungsviskosität ηᵣₑₗ im Bereich von 1,45 bis 2,3, insbesondere im Bereich von 1,5 bis 2,0 oder 1,5 bis 1,8.

Die erfindungsgemäßen Polyamide (A1_2) können auf üblichen Polykondensationsanlagen über die Prozessfolge Vorkondensat und Nachkondensation hergestellt werden. Für die Polykondensation werden zur Regelung der Viskosität bevorzugt die beschriebenen Kettenregler eingesetzt. Zusätzlich kann die Viskosität durch den Einsatz eines Diamin- oder Dicarbonsäureüberschusses eingestellt werden.

**Komponente (A1_3):** Bei den Polyamiden A1_3 sind die Copolyamide 6I/6T, 10I/10T, 12/6T, MXD6/MXDI bevorzugt. Möglich sind auch Systeme des Typs MXDI, MXDI/6I, MXD6/MXDI. Besonders bevorzugt sind die amorphen Copolyamide 6I/6T, 10I/10T und 12/6T mit einem Anteil von weniger als 50 Mol-% 6T-Einheiten. Bevorzugt werden insbesondere PA 6I/6T und PA 10I/10T, wobei ein Zusammensetzungsbereich T:I (T steht für Terephthalsäure, I für Isophthalsäure) von 20:80 bis 45:55 bevorzugt wird. Im Hinblick auf die Copolyamide MXD6/MXDI werden MXD6 reiche Zusammensetzungen bevorzugt, insbesondere mit einem MXD6-Gehalt von grösser als 80 mol-%, besonders bevorzugt im Bereich von 82 bis 95 mol-%. Besonders bevorzugt ist Komponente (A1_3) ausgewählt als Polyamid PA 10I/10T mit einem I:T-Verhältnis im Bereich von 75:25 bis 50:50, bevorzugt im Bereich von 70:30 bis 55:45 und insbesondere von 60:40. Im Vergleich zum Copolyamid PA 6I/6T wird durch PA 10I/10T der Schwund quer zur Spritzrichtung deutlich reduziert (von 0.3% auf 0.1%).

Bevorzugtermassen handelt es sich bei der **Komponente (A1_4)** um ein amorphes oder mikrokristallines Polyamid auf Basis von cycloaliphatischen und gegebenenfalls zusätzlich aliphatischen Diaminen, aliphatischen, cycloaliphatischen oder aromatischen Dicarbonsäuren, Lactamen und/oder Aminocarbonsäuren, bevorzugt mit 6 bis 40, insbesondere bevorzugt 6 - 36 Kohlenstoffatomen, oder um eine Mischung solcher Homopolyamide und/oder Copolyamide.

Geeignete cycloaliphatische Diamine sind beispielsweise Bis-(4-amino-3-methylcyclohexyl)-methan (MACM), Bis (4-amino-3-ethyl-cyclohexyl)-methan (EACM), Bis-(4-amino-3,5-dimethyl-cyclohexyl)-methan (TMDC), Isophorondiamin (IPD), 1,3-Bis-(aminomethyl)-cyclohexan (BAC) und/oder Bis-(4-aminocyclohexyl)-methan (PACM), mit oder ohne zusätzliche Substituenten, insbesondere Alkyl-Substituenten. Des Weiteren kann es sich bei der aliphatischen Dicarbonsäure um eine aliphatische Dicarbonsäure mit 2-36, bevorzugt 6-20 linear oder verzweigt angeordneten Kohlenstoffatomen, insbesondere bevorzugt mit 10, 12, 14, 16 oder 18 Kohlenstoffatomen handeln.

Gemäss einer weiteren bevorzugten Ausführungsform handelt es sich beim Polyamid (A1_4) um ein Homopolyamid oder Copolyamid ausgewählt aus der Gruppe MACM9, MACM10, MACM12, MACM14, MACM16, MACM18, PACM12, PACM14, PACM16, PACM18, MACM12/PACM12, MACM14/PACM14, MACM16/PACM16, MACM18/PACM18, PACM9-18, MACMI/12, 6I/6T/MACMI/MACMT/12, 6I/MACMI/MACMT, 6I/PACMI/PACMT, MACMI/MACMT/12, 6I/6T/MACMI, MACMI/MACM36, 12/PACMI oder 12/MACMT, 6I/PACMT, 6/IPDT, BACI/BACT, MACM12/BAC12, 10I/10T/BACI/BACT oder eine Mischung solcher Polyamide. Besonders bevorzugte Polyamide (A1_2) sind MACM12, MACM14, MACM18, PACMI2/MACMI2, MACMI/12 und MACMI/MACMT/12. Polyamid (A1_4), insbesondere in Form eines amorphen oder mikrokristallinen Homopolyamids und/oder Copolyamids, verfügt bevorzugtermassen über eine Lösungsviskosität (ηrel) zwischen 1.3 und 2.0, insbesondere bevorzugt zwischen 1.40 und 1.85, und/oder eine Glasübergangstemperatur Tg oberhalb von 90°C, bevorzugt oberhalb von 110°C, insbesondere bevorzugt oberhalb von 130°C. Weiter ist es bevorzugt, wenn das Polyamid (A1_4) ein mikrokristallines Polyamid mit einer Schmelzenthalpie im Bereich von 4-40 J/g, insbesondere im Bereich von 4-25 J/g, ist.

Eine ganz besonders bevorzugte Ausführungsform zeichnet sich dadurch aus, dass es sich beim Polyamid (A1_4) um MACM12-18 und/oder MACMI/12 und/oder MACMI/MACMT/12 handelt.

Bei der Komponente (A1_4) handelt es sich um amorphe oder mikrokristalline Polyamide, welche bevorzugtermassen eine Glasübergangstemperatur im Bereich von 90 bis 180 °C, bevorzugt im Bereich von 110 bis 170 °C und insbesondere im Bereich von 115 bis 165 °C besitzen und bevorzugt aus
a) 60 bis 100 mol-%, insbesondere 80 bis 100 mol-% mindestens einer aliphatischen und/oder aromatischer Dicarbonsäure mit 6 bis 14 oder 6 bis 12 Kohlenstoffatomen sowie 0 bis 40 mol-%, insbesondere 0 bis 20 mol-% mindestens einer cycloaliphatischen Dicarbonsäure mit 8 bis 20 Kohlenstoffatomen, bezogen auf die Gesamtmenge der Dicarbonsäuren;
b) 50 bis 100 mol-%, bevorzugt 70 bis 100 mol-%, besonders bevorzugt 85 bis 100 mol-% mindestens eines cycloaliphatischen Diamins, vorzugsweise mit 6 bis 20 Kohlenstoffatomen, wie z.B. PACM, MACM, EACM, TMDC, BAC und IPDA sowie 0 bis 50 mol-%, bevorzugt 0 - 30mol-%, besonders bevorzugt 0 -15 mol-% mindestens eines aliphatischen Diamins, mit 4-18 Kohlenstoffatomen, vorzugsweise mit 6 bis 12 Kohlenstoffatomen und/oder 0 bis 100 mol-% mindestens eines araliphatischen Diamins, wie z.B. MXDA (meta-Xylylendiamin) und PXDA (para-Xylylendiamin), bezogen auf die Gesamtmenge der Diamine, sowie gegebenenfalls;
c) Aminocarbonsäuren und/oder Lactamen je mit 6 bis 12 Kohlenstoffatomen; gebildet sind.

Gemäß einer bevorzugten Ausführungsform wird dabei das Polyamid der Komponente (A1_4) auf Basis von wenigstens 75 Mol-%, insbesondere von wenigstens 80 Mol-% cycloaliphatisches Diamin und wenigstens 80 Mol-%, bevorzugt wenigstens 90 Mol-%, insbesondere wenigstens 95 Mol-% einer aliphatischen oder aromatischen Dicarbonsäure mit 4 bis 18 Kohlenstoffatomen, vorzugsweise mit 6-12 Kohlenstoffatomen, und gegebenenfalls weiteren Lactamen und/oder Aminocarbonsäuren, gebildet.

Besonders bevorzugt werden die Polyamide (A1_4) aus folgenden Komponenten gebildet:
(a) Dicarbonsäuren: 80 - 100 Mol-% Isophthalsäure, Terephthalsäure, Sebazinsäure, Dodecandisäure bezogen auf den Gesamtgehalt an anwesenden Dicarbonsäuren;
(b) Diamine: 80 - 100 Mol-% mindestens eines cycloaliphatischen Diamins mit 6-36 Kohlenstoffatomen, vorzugsweise mit 12 bis 20, besonders bevorzugt 13 bis 17 Kohlenstoffatomen, bezogen auf den Gesamtgehalt an anwesenden Diaminen, 0 - 20 Mol-% aliphatische Diamine, vorzugsweise mit 4 bis 20 Kohlenstoffatomen, wobei in den hochschmelzenden Polyamiden der prozentuale Molgehalt an Dicarbonsäuren 100 % und der prozentuale Molgehalt an Diaminen 100 % ausmacht, und gegebenenfalls aus:
(c) Aminocarbonsäuren und/oder Lactamen, enthaltend Lactame mit bevorzugt 6 bis 12 Kohlenstoffatomen, und/oder Aminocarbonsäuren mit bevorzugt 6 bis 12 Kohlenstoffatomen.

Während die Komponenten (a) und (b) weitgehend äquimolar eingesetzt werden, beträgt die Konzentration von (c) höchstens 40 Gew.-%, bevorzugt höchstens 35 Gew.-%, insbesondere höchstens 30 Gew.-%, jeweils bezogen auf die Summe von (a) bis (c). Zusätzlich zu den weitgehend äquimolar eingesetzten Komponenten und können Dicarbonsäuren oder Diamine zur Regelung der Molmasse oder zum Ausgleich von Monomerverlusten bei der Polyamidherstellung eingesetzt werden, sodass in ihrer Gesamtheit die Konzentration einer Komponente überwiegen kann.

Als cycloaliphatische Diamine können beispielsweise Cyclohexandiamin, 1,3-Bis-(aminomethyl)-cyclohexan (BAC), Isophorondiamin, Norbornandimethylamin, 4,4'-Diaminodicyclohexylmethan (PACM), 2,2-(4,4'-Diaminodicyclohexyl)propan (PACP) und 3,3'-Dimethyl-4,4'-diaminodicyclohexylmethan (MACM) verwendet werden. EACM, TMDC Als araliphatische Diamine seien m-Xylylendiamin (MXDA) und p-Xylylendiamin (PXDA) erwähnt.

Zusätzlich zu den beschriebenen Dicarbonsäuren und Diaminen können noch Lactame und/oder Aminocarbonsäuren als polyamidbildende Komponenten eingesetzt werden. Geeignete Verbindungen sind beispielsweise Caprolactam (CL), α,ω-Aminocapronsäure, α,ω-Aminononansäure, α,ω-Aminoundecansäure (AUA), Laurinlactam (LL) und α,ω-Aminododecansäure (ADA). Die Konzentration der zusammen mit den Komponenten (A1a) und (Alb) eingesetzten Aminocarbonsäuren und/oder Lactame beträgt höchstens 20 Gew.-%, bevorzugt höchstens 15 Gew.-% und besonders bevorzugt höchstens 12 Gew.-%, bezogen auf die Summe der Komponenten (A1a) bis (A1c). Speziell bevorzugt sind Lactame bzw. α,ω-Aminosäuren mit 4, 6, 7, 8, 11 oder 12 C-Atomen. Dies sind die Lactame Pyrrolidin-2-on (4 C-Atome), ε-Caprolactam (6 C-Atome), Önanthlactam (7 C-Atome), Capryllactam (8 C-Atome), Laurinlactam (12 C-Atome) bzw. die α,ω-Aminosäuren 1,4-Aminobutansäure, 1,6-Aminohexansäure, 1,7-Aminoheptansäure, 1,8-Aminooctansäure, 1,11-Aminoundecansäure und 1,12-Aminododecansäure. In einer besonders bevorzugten Ausführungsform ist Komponente A2 frei von Caprolactam bzw. Aminocapronsäure.

Bevorzugtermassen ist Komponente (A1_4) ausgewählt aus der Gruppe bestehend aus Polyamid PA MACM12, PA MACMI/12, PA MACMT/MACMI/12.

Zur Regelung der Molmasse, der relativen Viskosität bzw. der Fliessfähigkeit oder des MVR können dem Ansatz und/oder dem Vorkondensat (vor der Nachkondensation) Regler in Form von Monocarbonsäuren oder Monoaminen zugesetzt werden. Als Regler geeignete, aliphatische, cycloaliphatische oder aromatische Monocarbonsäuren oder Monoamine sind Essigsäure, Propionsäure, Buttersäure, Valeriansäure, Capronsäure, Laurinsäure, Stearinsäure, 2-Ethylhexansäure, Cyclohexansäure, Benzoesäure, 3-(3,5-di-tert-butyl-4-hydroxyphenyl)propansäure, 3,5 -di-tert-butyl-4-hydroxybenzoesäure, 3-(3-tert-butyl-4-hydroxy-5-methylphenyl)propansäure, 2-(3,5-di-tert-butyl-4-ydroxybenzylthio)essigsäure, 3,3-bis(3-tert-butyl-4-hydroxyphenyl)butansäure, Butylamin, Pentylamin, Hexylamin, 2-Ethylhexylamin, n-Octylamin, n-Dodecylamin, n-Tetradecylamin, n-Hexadecylamin, Stearylamin, Cyclohexylamin, 3-(Cyclohexylamino)-propylamin, Methylcyclohexylamin, Dimethylcyclohexylamin, Benzylamin, 2-Phenylethylamin, 2,2,6,6-tetramethylpiperidin-4-amin, 1,2,2,6,6-pentamethylpiperidin-4-amin, 4-amino-2,6-di-tert-butylphenol u.a. Die Regler können einzeln oder in Kombination benutzt werden. Es können auch andere monofunktionelle Verbindungen als Regler eingesetzt werden, die mit einer Amino- oder Säuregruppe reagieren können, wie Anhydride, Isocyanate, Säurehalogenide oder Ester. Die übliche Einsatzmenge der Regler liegt zwischen 10 und 200 mmol pro kg Polymer.

Bezüglich einer Polymermischung enthaltend die Polyamidkomponenten A1, werden folgende Zusammensetzungen bevorzugt:
- (A1_1):: PA 610 oder PA 612 oder PA 1010 oder PA 1012 oder PA 1210 oder PA1212 oder PA 11 oder PA 12
- (A1_3):: PA 6T/6I oder PA 10T/10I, wobei der 6I- bzw. 101-Anteil 55 - 80 (bevorzugt 60-75) mol-% beträgt.
- (A1_1):: PA 66 oder PA6 oder eine Mischung aus PA 6 und PA66, im Verhältnis von 1:1 bis 1:4, insbesondere im Verhältnis von 1:3 bis 1:4;
- (A1_3):: PA 6I/6T, wobei das Mol-Verhältnis im Bereich von 65:35 bis 75:25 liegt oder insbesondere 67:33 beträgt.
- (A1_1):: PA 66 oder PA 610 oder PA 612 oder PA 1010 oder PA 1012 oder PA 1210 oder PA1212 oder PA 11 oder PA 12
- (A1_3):: PA MXD6/MXDI, wobei im Copolyamid das Mol-Verhältnis im Bereich von 70:30 bis 90:10 liegt oder insbesondere 88:12 beträgt.

Dabei liegt bevorzugtermassen der Anteil der Komponente (A1_1) jeweils im Bereich von 50 bis 90 Gew.-%, insbesondere von 60 bis 85 Gew.-% und Komponente (A1_3) bevorzugt im Bereich von 10 bis 50 Gew.-%, insbesondere im Bereich von 15 bis 40 Gew.-%.

Bezüglich einer Polymermischung enthaltend die Polyamidkomponenten A1_2 und A1_3, werden folgende Zusammensetzungen bevorzugt:
- (A1_2):: PA 6T/10T (5 bis 40 / 60 - 95 mol-%)
- (A1_3):: PA 6I/6T oder PA 10I/10T, wobei das Mol-Verhältnis I:T im Bereich von 55:45 bis 75:25 oder insbesondere im Bereich von 60:40 bis 70:30 liegt.
- (A1_2):: PA 6T/10T/6I;
- (A1_3):: PA 6I/6T oder PA 10I/10T, wobei das Mol-Verhältnis I:T im Bereich von 55:45 bis 75:25 oder insbesondere im Bereich von 60:40 bis 70:30 liegt.
- (A1_2):: PA 6T/6I, wobei das Mol-Verhältnis im Bereich von 60:40 bis 75:25 liegt;
- (A1_3):: PA 6I/6T, wobei das Mol-Verhältnis im Bereich von 65:35 bis 75:25 liegt oder insbesondere 67:33 beträgt.
- (A1_2):: PA6T/10T (5 bis 40 / 60 - 95 mol-%)
- (A1_3):: PA MXD6/MXDI, wobei im Copolyamid das Mol-Verhältnis im Bereich von 70:30 bis 90:10 liegt oder insbesondere 88:12 beträgt.

Dabei liegt bevorzugtermassen der Anteil der Komponente (A1_2) jeweils im Bereich von 50 bis 90 Gew.-%, insbesondere von 60 bis 85 Gew.-% und Komponente (A1_3) bevorzugt im Bereich von 10 bis 50 Gew.-%, insbesondere im Bereich von 15 bis 40 Gew.-% jeweils bezogen auf Komponente (A1) als ganzes.

**Komponente (B)** (LDS-Additiv): Bevorzugt liegt der Anteil an Komponente (B) im Bereich von 2-8 Gew.-%, vorzugsweise im Bereich von 2-6 Gew.-%.

Die Komponente (B) ist bevorzugt ein LDS-Additiv mit einem von Null verschiedenen Absorptionskoeffizienten für UV-, VIS- oder IR-Strahlung, welches unter Einwirkung von elektromagnetischer Strahlung, bevorzugt als Laserstrahlung, Metallkeime bildet, die in einem chemischen Metallisierverfahren die Abscheidung von Metallschichten zur Erzeugung von Leiterbahnen an den bestrahlten Stellen auf der Formteiloberfläche erleichtern und/oder ermöglichen und/oder verbessern, wobei das LDS-Additiv vorzugsweise eine Absorptionsfähigkeit im sichtbaren und infraroten Strahlungsbereich aufweist mit einem Absorptionskoeffizient von wenigstens 0.05, bevorzugt wenigstens 0.1 und insbesondere wenigstens 0.2, und/oder dass ein Absorber vorgesehen ist, der die Strahlungsenergie auf das LDS-Additiv überträgt.

Die Komponente (B) ist bevorzugt ein LDS-Additiv mit einer mittleren Partikelgrösse (D50) im Bereich von 50 - 10000 Nanometer, bevorzugt 200 bis 5000 Nanometer und besonders bevorzugt 300 bis 4000 Nanometer, und/oder einem Aspektverhältnis von höchstens 10, insbesondere von höchstens 5. Der als Mass für die Partikelgrösse angegebene D50-Wert ist ein Maß für die mittlere Teilchengröße, wobei 50 VolumenProzent der Probe feiner und die anderen 50% der Probe grober sind als der D50-Wert (Median).

In einer bevorzugten Ausführungsform handelt es sich bei Komponente (B) um ein LDS (Laser Direct Structuring)-Additiv ausgewählt aus der Gruppe der Metalloxide, insbesondere sogenannte Spinelle mit der allgemeinen chemischen Formel

MX₂O₄

wobei steht M für ein Metallkation mit der Wertigkeit 2, wobei bevorzugt M ausgewählt ist aus der Gruppe bestehend aus: Magnesium, Kupfer, Kobalt, Zink, Zinn, Eisen, Mangan und Nickel sowie Kombinationen davon;

X für ein Metallkation der Wertigkeit 3, wobei bevorzugt X ausgewählt ist aus der Gruppe bestehend aus: Mangan, Nickel, Kupfer, Kobalt, Zinn, Titan, Eisen, Aluminium und Chrom sowie Kombinationen davon,
wobei insbesondere bevorzugt das LDS-Additiv ein Kupfereisenspinell, ein kupferhaltiges Magnesiumaluminiumoxide, ein Kupfer-Chrom-Mangan-Mischoxid, ein Kupfer-Mangan-Eisen-Mischoxid, gegebenenfalls jeweils mit Sauerstofffehlstellen, oder Salze und Oxide des Kupfers, wie insbesondere Kupfer(I)oxid, Kupfer(II)oxid, basische Kupferphosphate, Kupferhydroxylphosphat, Kupfersulfat, sowie Metallkomplexverbindungen, insbesondere Chelatkomplexe von Kupfer, Zinn, Nickel, Cobalt, Silber und Palladium oder Mischungen solcher Systeme, und/oder insbesondere ausgewählt aus der folgenden Gruppe: Kupfer-Chrom-Mangan-Mischoxide, Kupfer-Mangan-Eisen-Mischoxide, Kupferchromoxid, Zink-Eisenoxid, Kobalt-Chromoxid, Kobalt-Aluminiumoxid, Magnesiumaluminiumoxid, sowie Mischungen und/oder oberflächenbehandelte und/oder Sauerstofffehlstellen aufweisende Formen hiervon. Möglich sind z.B. Systeme, wie sie beispielsweise in WO-A-2000/35259 oder in Kunststoffe 92 (2002) 11, 2-7 beschrieben werden.

Ebenfalls bevorzugt wird als Komponente (B) um ein LDS (Laser Direct Structuring)-Additiv ausgewählt aus der Gruppe der Metalloxide, Metallmischoxide, Metallhydroxidoxide, Metallsulfidoxide auf Basis von Zinn. Besonders bevorzugt sind Zinnoxid, Antimonoxid, Mischungen aus Zinn- und Antimonoxid, Wismutneodymat (Bi₂O₃·Nd₂O₃), Kupfermolybdat (CuO·xMoO₃), Mischungen aus Zinn- und Indiumoxid, Mischungen aus Zinnoxid und Zinnfluorid.

Besonders bevorzugt ist Zinnoxid und dotiertes Zinnoxid, wobei die Dotierung mit Antimon, Indium, Wismut, Molybdän, Aluminium, Titan, Silicium, Eisen, Kupfer, Silber, Nickel und Kobalt erfolgen kann. Insbesondere wird Zinnoxid, das mit Antimon, Titan oder Kupfer dotiert ist, bevorzugt. Weiterhin werden Mischungen aus Zinnoxid und mindestens einem weiteren Metalloxid, insbesondere Antimonoxid als LDS-Additive bevorzugt. Als weiteres Metalloxide werden dabei sowohl farblose hochbrechende Metalloxide, wie insbesondere Titandioxid, Antimon(III)oxid, Zinkoxid, Zinnoxid, Ceroxid und/oder Zirkoniumdioxid verwendet als auch farbige Metalloxide wie z.B. Chromoxid, Nickeloxid, Kupferoxid, Kobaltoxid und insbesondere Eisenoxid (Fe₂O₃, Fe₃O₄). Insbesondere bevorzugt wird die Mischung aus Zinnoxid und Antimon(III)oxid verwendet.

Vorzugsweise sind die dotierten Zinnoxide bzw. Metalloxid-Mischungen bzw. Zinnoxid als Schichten auf plättchenförmigen Substraten, insbesondere Schichtsilikaten, wie z.B. synthetischer oder natürlicher Glimmer, Talkum, Kaolin, Glasplättchen oder SiO2-Plättchen, ausgebildet. Als Substrat für die Metalloxide werden insbesondere Glimmer bzw. Glimmerschuppen bevorzugt. Weiterhin kommen als Substrate auch plättchenförmige Metalloxide wie z. B. plättchenförmiges Eisenoxid, Aluminiumoxid, Titandioxid, Siliziumdioxid, LCP's (Liquid Crystal Polymers), holographische Pigmente oder beschichtete Graphitplättchen in Betracht.

Weiterhin ist Komponente (B) bevorzugt ausgewählt unter Phosphaten, kondensierten Phosphaten, Phosphonaten, Phosphiten und gemischten Hydroxid-Phosphat-Oxoanionen von Kupfer (Cu), Zinn (Sn), und/oder Eisen (Fe), insbesondere unter Metallphosphaten, basischen Metallphosphaten oder Metallhydroxidphosphaten, bevorzugt auf Basis von anorganischen Verbindungen des Kupfers und/oder Zinns, insbesondere Trizinnphosphat (CAS 15578-32-3), Trikupferphosphat (CAS 7798-23-4), Kupferdiphosphat (CAS 10102-90-6), Kupferhydroxidphosphat (CAS 12158-74-6), Kupferzinnphosphat und Gemischen davon ausgewählt.

Besonders bevorzugt werden die LDS-Additive basisches Kupferphosphat, Kupferhydroxidphosphat, Kupfer-Zinn-Phosphat, basisches Kupfer-Zinn-Phosphat, Zinnphosphat, basisches Zinnphosphat und antimondotiertes Zinnoxid, wobei Letzteres bevorzugt in Kombination mit Glimmer Verwendung findet. Besonders bevorzugt werden LDS-Additive auf Basis von Glimmer, wobei die Glimmeroberfläche mit metalldotierten Zinnoxiden beschichtet ist, weil diese eine höhere Farbhelligkeit in der Formmasse ermöglichen. Insbesondere bevorzugt wird antimondotiertes Zinnoxid.

Beispiele für kommerziell erhältliche LDS-Additive gemäss der vorliegenden Erfindung sind: Iriotec 8820, 8825, 8830 und Minatec 230 A-IR der Firma Merck, Stanostat CP40W, Stanostat CP15G, Stanostat CP5C der Firma Keeling&Walker.

Bei Komponente (B) kann es sich also um ein LDS-Additiv handeln ausgewählt aus der folgenden Gruppe: dotierte Zinnoxide, bevorzugt Antimon dotierte Zinnoxide; Metalloxid-Mischungen mit Zinnoxid, die als Schichten auf plättchenförmigen Substraten, insbesondere Schichtsilikaten, wie bevorzugt synthetischem oder natürlichem Glimmer, Talkum, Kaolin, Glasplättchen oder SiO₂-Plättchen, ausgebildet sind; Metall- oder Metalloxid-dotiertes Zinnoxid; Metalloxidbeschichteter Glimmer; mit Antimon-dotiertem Zinnoxid beschichteter Glimmer; Mischung aus Zinnoxid und Antimonoxid und optional weiterer Metalloxide; Kupferchromoxid; Kupferoxid; Kupferhydroxid; Kupferhydroxidphosphat; Kupferphosphat; basische Kupferphosphate; Kupfer-Zinn-Phosphat; basisches Kupfer-Zinn-Phosphat; Zinnphosphat; basisches Zinnphosphat; oder eine Mischung solcher LDS-Additive.

Die besonders bevorzugten LDS-Additive sind: Kupferchromit, Kupferhydroxylphosphat und antimondotiertes Zinnoxid, wobei Letzteres bevorzugt als in Kombination mit Glimmer Verwendung findet.

Bevorzugt liegt der Anteil an **Komponente (C)** im Bereich von 0.5-50 Gew.-%, vorzugsweise im Bereich von 1-40 Gew.-% und besonders bevorzugt im Bereich von 1 - 30 Gew.-% oder 2 - 25 Gew-%. Die Komponente (C) ist dabei vorzugsweise aufgebaut aus partikulären Füllstoffen (C1) und/oder Verträglichkeitsvermittern oder Schlagzähmodifiatoren (C2) und/oder faserförmigen Füllstoffen (C3) und/oder Additiven (C4).

Als **partikuläre Füllstoffe (C1)** der Komponente (C) kommen die dem Fachmann an sich bekannten Füllstoffe in Frage. Hierzu zählen insbesondere partikuläre Füllstoffe ausgewählt aus der Gruppe bestehend aus Talk (Magnesiumsilikat), Glimmer, Silikaten, Quarz, Wollastonit, Kaolin, Kieselsäuren, Magnesiumcarbonat, Magnesiumhydroxid, Kreide, gemahlenem oder gefälltem Calciumcarbonat, Kalk, Feldspat, anorganische Pigmente, wie z.B., Eisenoxid oder Eisenmanganoxid oder insbesondere Weisspigmente, wie Bariumsulfat, Zinkoxid, Zinksulfid, Lithopone und Titandioxid (Rutil, Anatas), permanentmagnetischen oder magnetisierbaren Metallen oder Legierungen, hohlkugeligen Silikatfüllstoffen, Aluminiumoxid, Bornitrid, Borcarbid, Aluminiumnitrid, Calciumfluorid, Glaskugeln, Glashohlkugeln und Mischungen hiervon. Die Füllstoffe können auch oberflächenbehandelt sein.

(C1) hat bevorzugtermassen eine mittlere Partikelgrösse (D50) im Bereich von 0.1-40 µm, bevorzugt im Bereich von 0.1-20 µm, insbesondere im Bereich von 0.1-10 µm verfügen.

Diese partikulären Füllstoffe (Komponente C1) haben bevorzugtermassen eine mittlere Partikelgrösse (D50) im Bereich von 0.1-40 µm, bevorzugt im Bereich von 0.2-20 µm, insbesondere im Bereich von 0.3-10 µm. Bevorzugt wird eine Form der partikulären Füllstoffe, bei denen die Aspektverhältnisse L/b1 und L/b2 beide höchstens 10, insbesondere höchstens 5 sind, wobei die Aspektverhältnisse durch die Quotienten aus grösster Länge L des Teilchens zu dessen mittleren Breite b1 oder b2 beschrieben werden. Dabei liegen b1 und b2, die senkrecht zueinander angeordnet sind, in einer zur Länge L senkrechten Ebene.

Als **Komponente (C2)** werden Verträglichkeitsvermitter oder Schlagzähmodifiatoren auf Basis von modifizierten Polyolefinen, Kautschuk, EPDM, vinylaromatischen Polymeren, Polyolefin-co-(meth)acrlyat-Copolymeren oder Polyphenylenethern eingesetzt. Bevorzugtermassen verfügt die Komponente (C2) über Bestandteile mit Säureanhydridgruppen, die durch thermische oder radikalische Reaktion des Hauptkettenpolymers mit einem ungesättigten Dicarbonsäureanhydrid, einer ungesättigten Dicarbonsäure oder einem ungesättigten Dicarbonsäuremonoalkylester in einer Konzentration eingebracht werden, die für eine gute Anbindung an das Polyamid ausreicht, wobei dafür Reagenzien ausgewählt aus der folgenden Gruppe bevorzugtermassen eingesetzt werden: Maleinsäure, Maleinsäureanhydrid, Maleinsäuremonobutylester, Fumarsäure, Aconitsäure und/oder Itaconsäureanhydrid.

Besonders bevorzugt sind durch Pfropfen mit Maleinsäureanhydrid funktionalisierte Mischpolymerisate des Butadiens mit Styrol, unpolare oder polare Olefinhomo- und Copolymere, die durch Pfropfen mit Maleinsäureanhydrid entstanden sind und carbonsäurefunktionalisierte Copolymere wie Poly(ethen-co-(meth)arylsäure) oder Poly(ethen-co-1-olefin-co-(meth)acrylsäure), in denen die Säuregruppen teilweise mit Metallionen neutralisiert sind.

Faserförmige Verstärkungsmittel (C3), insbesondere Glasfasern, können im Bereich von 0-30, bevorzugt 1-20 und besonders bevorzugt im Bereich von 2-15 Gew.-% bezogen auf die gesamte Formmasse eingesetzt werden.

Glasfasern **(Komponente C3)** können z.B. in Form von sogenannten Kurzfasern (z.B. Schnittglas mit einer Länge von 0.2-20 mm) oder Endlosfasern (Rovings) verwendet werden. Die Glasfasern können unterschiedliche Querschnittsflächen aufweisen, wobei Glasfasern mit kreisförmigem Querschnitt (runde Fasern) und mit nicht-kreisförmigem Querschnitt (flache Fasern) bevorzugt sind.

Glasfaser mit kreisförmigem Querschnitt, also runde Glasfasern, haben einen Durchmesser im Bereich von 5-20 µm, bevorzugt im Bereich von 6-13 µm und besonders bevorzugt im Bereich von 6-10 µm. Sie werden bevorzugt als Kurzglasfaser (Schnittglas mit einer Länge von 0.2 bis 20 mm, bevorzugt 2-12 mm) eingesetzt.

Bei den flachen Glasfasern, also Glasfasern mit nicht-kreisförmiger Querschnittsfläche, werden solche mit einem Abmessungsverhältnis von der Hauptquerschnittsachse zur senkrecht darauf stehenden Nebenquerschnittsachse von mehr als 2.5, bevorzugt im Bereich von 2.5 bis 6, insbesondere im Bereich von 3 bis 5 bevorzugt eingesetzt. Diese sogenannten flachen Glasfasern weisen eine ovale, elliptische, mit Einschnürung(en) versehene elliptische (sogenannte Kokon- oder cocoon-Faser), polygonale, rechteckige oder nahezu rechteckige Querschnittsfläche auf.

Vorzugsweise ist die Komponente (C3) ausgewählt aus der Gruppe bestehend aus: E-Glasfasern (diese bestehen gemäss ASTM D578-00 aus 52-62% Siliciumdioxid, 12-16% Aluminiumoxid, 16-25% Calciumoxid, 0-10% Borax, 0-5% Magnesiumoxid, 0-2% Alkalioxide, 0-1.5% Titandioxid und 0-0.3% Eisenoxid; bevorzugt haben sie eine Dichte von 2.58±0.04 g/cm3, einen Zug-E-Modul von 70-75 GPa, eine Zugfestigkeit von 3000-3500 MPa und eine Reissdehnung von 4.5-4.8%), A-Glasfasern (63-72% Siliciumdioxid, 6-10% Calciumoxid, 14-16% Natrium- und Kaliumoxid, 0-6% Aluminiumoxid, 0-6% Boroxid, 0-4% Magnesiumoxid), C-Glasfasern (64-68% Siliciumdioxid, 11-15% Calciumoxid, 7-10% Natrium- und Kaliumoxid, 3-5% Aluminiumoxid, 4-6% Boroxid, 2-4% Magnesiumoxid), D-Glasfasern (72-75% Siliciumdioxid, 0-1% Calciumoxid, 0-4% Natrium- und Kaliumoxid, 0-1% Aluminiumoxid, 21-24% Boroxid), Basaltfasern (Mineralfaser mit der ungefähren Zusammensetzung: 52% SiO₂ 17% Al₂O₃, 9% CaO, 5% MgO, 5% Na₂O, 5% Eisenoxid sowie weiteren Metalloxiden), AR-Glasfasern (55-75% Siliciumdioxid, 1-10% Calciumoxid, 11-21% Natrium- und Kaliumoxid, 0-5% Aluminiumoxid, 0-8% Boroxid, 0-12%Titandioxid, 1-18% Zirkonoxid, 0-5% Eisenoxid) sowie Mischungen davon.

Die erfindungsgemässen Glasfasern können mit einer für Thermoplaste, insbesondere für Polyamid geeigneten Schlichte, enthaltend einen Haftvermittler auf Basis einer Amino- oder Epoxysilanverbindung, versehen sein.

Additive der **Komponente (C4):** Die erfindungsgemäßen thermoplastischen Polyamidformmassen können weiterhin dem Fachmann allgemein bekannte Zusatzstoffe in Form der Additive (C2) enthalten, die bevorzugt aus der Gruppe bestehend aus: Haftvermittlern, halogenhaltigen Flammschutzmitteln, halogenfreien Flammschutzmitteln, Stabilisatoren, Alterungsschutzmitteln, Antioxidantien, Antiozonantien, Lichtschutzmitteln, UV-Stabilisatoren, UV-Absorbern, UV-Blockern, anorganischen Hitzestabilisatoren, insbesondere auf Basis von Kupferhalogeniden und Alkalihalogeniden, organischen Hitzestabilisatoren, Leitfähigkeitsadditiven, Russ, optischen Aufhellern, Verarbeitungshilfsmitteln, Nukleierungsmitteln, Kristallisationsbeschleunigern, Kristallisationsverzögerern, Fliesshilfsmitteln, Gleitmitteln, Entformungsmitteln, Weichmachern, organische Pigmenten, organische Farbstoffen, Markierungsstoffen und Mischungen hiervon ausgewählt sind.

Weitere Ausführungsformen sind in den abhängigen Ansprüchen angegeben.

### KURZE BESCHREIBUNG DER ZEICHNUNGEN

Bevorzugte Ausführungsformen der Erfindung werden im Folgenden anhand der Zeichnungen beschrieben, die lediglich zur Erläuterung dienen und nicht einschränkend auszulegen sind. In den Figuren zeigt:

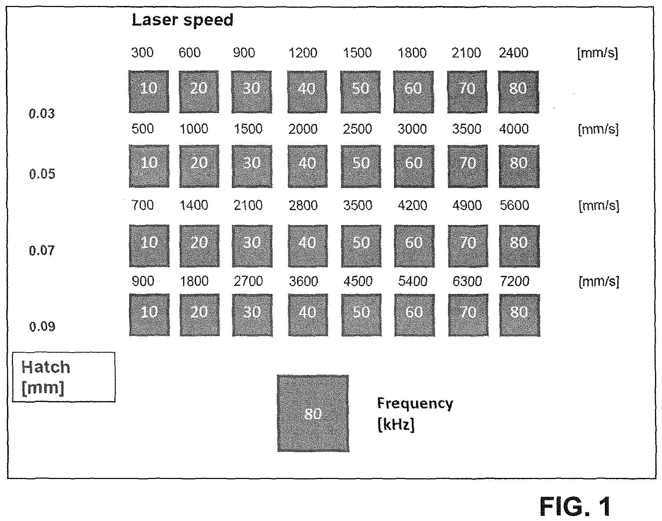

- Fig. 1: die Parameter der Laserstrukturierung.

### BESCHREIBUNG BEVORZUGTER AUSFÜHRUNGSFORMEN

Die Erfindung soll nachfolgend unter Verwendung von spezifischen Ausführungsbeispielen (B) beschrieben und mit den weniger leistungsfähigen Systemen nach dem Stand der Technik (VB) verglichen werden.

### Beispiele B1 bis B11 und Vergleichsbeispiele VB1 - VB3

Die in den Tabellen 2a, 2b und 3 angegebenen Komponenten werden in einem zweiwelligen Extruder der Firma Werner und Pfleiderer mit einem Schneckendurchmesser von 25 mm bei vorgegebenen Prozessparametern (siehe Tabelle 1) compoundiert, dabei werden die Polyamidgranulate sowie die Zusatzstoffe in die Einzugszone dosiert, während die gegebenenfalls verwendeten Glasfasern über einen Sidefeeder 3 Gehäuseeinheiten vor der Düse in die Polymerschmelze dosiert werden. Die Compounds wurden als Strang aus einer Düse mit 3 mm Durchmesser abgezogen und nach Wasserkühlung granuliert. Nach Granulierung und Trocknung bei 110°C für 24h wurden die Granulateigenschaften gemessen und die Prüfkörper hergestellt.

**Tabelle 1: Bedingungen für die Compoundierung, den Spritzguss und die Folienextrusion für die Beispiele und Vergleichsbeispiel**

| Verarbeitung | Parameter | Einheit | B1-B11, VB3 | VB1, VB2 |
|---|---|---|---|---|
| Compoundierung | Zylindertemperaturen | °C | 250-260 | 260-280 |
| | Schneckendrehzahl | Upm | 200 | 200 |
| | Durchsatz | kg/h | 15 | 15 |
| Spritzguss | Zylindertemperaturen | °C | 265-280 | 265-280 |
| | Werkzeugtemperatur | °C | 80 | 130 |
| | Massetemperatur | | 280 | 275 |
| Folienextrusion | Zylindertemperatur | °C | 220-265 | 260-275 |
| | Massetemperatur | °C | 250-260 | 265-275 |
| | Schneckendrehzahl | U/min | 60 | 60 |
| | Abzugsgeschwindigkeit | m/min | 5.8 | 5.8 |
| | Temperatur Abzugswalze | °C | 60-62 | 70-72 |

### Verarbeitung:

Die Compounds wurden mit einer Spritzgussmaschine Arburg Allrounder 320-210-750 zu Probekörpern bei definierten Zylindertemperaturen der Zonen 1 bis 4 und einer definierten Werkzeugtemperatur (siehe Tabelle 1) verspritzt. Das im Spritzguss hergestellte Formteil in Form einer Platte für das Vergleichsbeispiel VB3 und Beispiel B11 verfügte über eine Dicke von 2 mm, die Dicke der ISO-Prüfkörper war 4 mm.

In Beispiel B11 wurde die Folie B7 (Dicke 100 µm) für die einzelnen Prüfkörper passgenau zugeschnitten und an die Innenwand des Formhohlraums platziert, so dass sie vollflächig anlag. Die Folie wurde dann unter den in Tab. 1 angegebenen Bedingungen mit der in Tab.3 angegebenen Formmasse hinterspritzt.

Die Herstellung der Folien erfolgte auf einem Einwellenextruder für die Beispiele B1 bis B11 und VB1 oder einer Coextrusionsanlage (z.B. VB2) für Flachfolien der Dr. Collin GmbH vom Typ E 30 mit einer (zwei) 30 mm 3-Zonen-Schnecke(n). Die Folien wurden mittels einer Breitschlitzdüse/Mehrschichtdüse hergestellt. Die Abmessungen der Folie waren 200 mm Breite bzw. 250 mm und 100 µm Dicke. Die Folien wurden mit Hilfe einer Chill-Roll aufgewickelt und auf die benötigte Länge geschnitten. Die weiteren Herstellparameter sind der Tabelle 1 zu entnehmen.

**Tabelle 2a: Zusammensetzung und Eigenschaften der Beispiele B1-B7**

| | Einheit | **B1** | **B2** | **B3** | **B4** | **B5** | **B6** | **B7** |
|---|---|---|---|---|---|---|---|---|
| ***Zusammensetzung*** | | | | | | | | |
| PA1010 mittelviskos | Gew.-% | 85.8 | 76.3 | 76.3 | | | | |
| PA1010 hochviskos | Gew.-% | | | | 76.3 | | | |
| PA6I/6T | Gew.-% | 9.5 | 19 | | | | 95.3 | |
| PA10I/10T | Gew.-% | | | 19 | 19 | | | |
| PA12 | Gew.-% | | | | | 57.3 | | |
| PAMACM12 | Gew.-% | | | | | 38 | | 95.3 |
| Nukleiierung | Gew.-% | 0.2 | 0.2 | 0.2 | 0.2 | 0.2 | 0.2 | 0.2 |
| LDS-Additiv | Gew.-% | 4 | 4 | 4 | 4 | 4 | 4 | 4 |
| Irganox 1098 | Gew.-% | 0.5 | 0.5 | 0.5 | 0.5 | 0.5 | 0.5 | 0.5 |

| ***Eigenschaften*** | | | | | | | | |
|---|---|---|---|---|---|---|---|---|
| Zug-E-Modul | MPa | 2100 | 2200 | 2000 | 2000 | 1500 | 2900 | 1600 |
| Zugfestigkeit | MPa | 56 | 61 | 59 | 61 | 59 | 90 | 62 |
| Reissdehnung | % | 35 | 40 | 140 | 50 | 230 | 10 | 120 |
| Schlagzähigkeit 23°C | kJ/m² | ohne Bruch | ohne Bruch | ohne Bruch | ohne Bruch | ohne Bruch | 50 | ohne Bruch |
| Kerbschlagzähigkeit 23°C | kJ/m² | 8 | 5 | 5 | 6 | 7 | 9 | 9 |
| Planarität der Folie | | | | | | | | |
| nach Folienherstellung | - | + | + | + | + | + | + | + |
| nach Laserstrukturierung | - | o | o | o | o | + | + | + |
| nach Metallisierung | - | o | - | - | o | + | - | + |
| Ablösung der Metallschicht bei 10-maligem Aufrollen (d=10mm) | - | nein | nein | nein | nein | nein | nein | nein |
| Metallisierbarkeit (Anteil metallisierter Felder) | % | 86 | 100 | 100 | 100 | 100 | 94 | 100 |

**Tabelle 2b: Zusammensetzung und Eigenschaften der Beispiele B8-B10 und VB1, VB2**

| | Einheit | **B8** | **B9** | **B10** | **VB1** | **VB2** |
|---|---|---|---|---|---|---|
| ***Zusammensetzung*** | | | | | | |
| PA1010 hochviskos | Gew.-% | 50 | | | | |
| PA12 | Gew.-% | | 35.5 | 45.5 | | |
| PAMACM12 | Gew.-% | 45.5 | 60 | | | |
| PAMACMI/12 | Gew.-% | | | 50 | | |
| PET | Gew.-% | | | | 75 | |
| PA6I/6T | Gew.-% | | | | 20 | |
| Aluminiumoxid | Gew.-% | | | | 1 | |
| LDS-Additiv | Gew.-% | 4 | 4 | 4 | 4 | |
| Irganox 1098 | Gew.-% | 0.5 | 0.5 | 0.5 | | |

| ***Eigenschaften*** | | | | | | |
|---|---|---|---|---|---|---|
| Zug-E-Modul | MPa | 2000 | 1550 | 2000 | 3400 | |
| Zugfestigkeit | MPa | 60 | 60 | 65 | 90 | |
| Reissdehnung | % | 180 | 190 | 160 | 15 | |
| Schlagzähigkeit 23°C | kJ/m² | ohne Bruch | ohne Bruch | ohne Bruch | ohne Bruch | |
| Kerbschlagzähigkeit 23°C | kJ/m² | 7 | 10 | 8 | 4 | |
| Planarität der Folie | | | | | | |
| nach Folienherstellung | | + | + | + | + | + |
| nach Laserstrukturierung | | + | + | + | o | o |
| nach Metallisierung | | + | + | + | - | - |
| Ablösung der Metallschicht bei 10-maligem Aufrollen (d=10mm) | - | nein | nein | nein | nein | Ablösung an den Kanten |
| Metallisierbarkeit (Anteil metallisierter Felder) | % | 100 | 100 | 100 | 75 | 63 |

Im Vergleichsbeispiel VB2 wurde eine 3-schichtige Folie mit der Schichtabfolge ABA, wobei die Schicht A eine 5 bis 10 µm dicke Schicht aus VB1 und die mittlere Schicht B eine 80 bis 90 µm dicke Schicht aus PET (ohne Zusätze) ist, der Laserstrukturierung und anschliessenden stromlosen Metallisierung unterzogen, ohne dass die Folie vorgängig verstreckt und thermofixiert wurde. Die nach der Extrusion glatte Folie verzog sich bei der Laserbestrahlung und wurde stark wellig.

**Tabelle 3: Zusammensetzung und Eigenschaften der Beispiele B11 und VB3**

| | ***Einheit*** | ***VB3*** | ***B11*** |
|---|---|---|---|
| | | Formteile im Spritzguss hergestellt | Formteile durch Hinterspritzen von Folie B7 hergestellt |
| ***Zusammensetzung Spritzgussteil bzw. hinterspritzter Thermoplast*** | | | |
| PA1010 | Gew.-% | 36.6 | 36.6 |
| PA6I/6T | Gew.-% | 9.1 | 9.1 |
| Glasfasern | Gew.-% | 50 | 54 |
| LDS-Additiv | Gew.-% | 4 | 0 |
| Irganox 1098 | Gew.-% | 0.3 | 0.3 |

| ***Eigenschaften*** | | | |
|---|---|---|---|
| Zug-E-Modul | MPa | 12900 | 14500 |
| Zugfestigkeit | MPa | 139 | 187 |
| Reissdehnung | % | 2.0 | 2.8 |
| Schlagzähigkeit 23°C | kJ/m² | 50 | 95 |
| Kerbschlagzähigkeit 23°C | kJ/m² | 9 | 20 |
| Metallisierbarkeit (Anteil metallisierter Felder) | % | 100 | 100 |
| Menge LDS-Additiv bezogen auf Formteil (Platte 60x60x2 mm)^{*)} | Gew.-% | 4.0 | 0.2 |

| | | | |
|---|---|---|---|
| ^{*)}Die Platte in B11 hat die Dimension 60x60x2 mm, wobei eine Oberfläche durch Folie B7 (Dicke 0.1 mm) gebildet ist. | | | |

### Materialien:

- PA 6I/6T (70:30): Amorphes, teilaromatisches Polyamid auf Basis von Terephthalsäure, Isophthalsäure und 1,6-Hexandiamin, mit einer Glasübergangstemperatur von 125°C und einer Lösungsviskosität von 1.54.
- PA 10I/10T (60:40): Amorphes, teilaromatisches Polyamid auf Basis von 1,10-Decandiamin, Isophthalsäure und Terephthalsäure, mit einer Glasübergangstemperatur von 101°C und einer Lösungsviskosität von 1.59.
- PA 1010: Teilkristallines, aliphatisches Polyamid auf Basis von 1,10-Decandiamin und Sebacinsäure, mit einem Schmelzpunkt von 200°C und einer Lösungsviskosität von 1.78 (mittelviskos) oder 2.06 (hochviskos).
- PA 12: Teilkristallines, aliphatisches Polyamid auf Basis von Laurinlactam, mit einem Schmelzpunkt von 178°C und einer Lösungsviskosität von 1.96.
- MACM12: Amorphes Polyamid auf Basis von MACM und DDDS, Tg = 156°C, ηrel = 1.82, ΔHm < 4 J/g, LT = 93%.
- MACMI/12: Amorphes Polyamid auf Basis von MACM, Isophthalsäure und Lactam-12; Tg=155°C, ηrel = 1.86, ΔHm < 4 J/g
- Glasfasern: Schnittglasfasern CSG3PA-820 aus E-Glas, mit einer Länge von 3 mm, einer Hauptquerschnittsachse von 28 µm, einer Nebenquerschnittsachse von 7 µm und einem Achsenverhältnis von 4 (nicht-kreisförmiger Querschnitt) von NITTO BOSEKI, Japan
- LDS-Additiv: Shepherd Schwarz 30C965 (The Shepherd Color Company), Kupferchromit (CuCr₂O₄), mittlere Partikelgrösse von 0.6 µm.
- Nukleiierung: Brüggolen P22, Brüggemann Chemical
- PET: Polyethylenterephthalat mit einer Standard Viskosität SV (Dichloressigsäure) von 800
- Aluminiumoxid: Aerosil 90, Evonik

### Messungen:

Die Messungen wurden nach folgenden Normen und an folgenden Prüfkörpern durchgeführt.

Der Zug-E-Modul wurde nach ISO 527 mit einer Zuggeschwindigkeit von 1 mm/min, die Streckspannung, die Reissfestigkeit und die Reissdehnung wurden bestimmt gemäss ISO 527 mit einer Zuggeschwindigkeit von 50 mm/min (unverstärkte Varianten) oder einer Zuggeschwindigkeit von 5 mm/min (verstärkte Varianten) bei einer Temperatur von 23 °C, wobei als Probekörper ein ISO-Zugstab , Norm: ISO/CD 3167, Typ A1, 170 x 20/10 x 4 mm, verwendet wurde.

Schlagzähigkeit und Kerbschlagzähigkeit nach Charpy wurden nach ISO 179 am ISO-Prüfstab, Norm: ISO/CD 3167, Typ B1, 80 x 10 x 4 mm bei Temperatur 23 °C gemessen. Das thermische Verhalten (Schmelztemperatur (Tm), Schmelzenthalpie (ΔHm), Glasumwandlungstemperatur (Tg)) wurde anhand der ISO-Norm 11357-11-2 am Granulat bestimmt. Die Differential Scanning Calorimetry (DSC) wurde mit Aufheizrate von 20 °C/min durchgeführt. Für die Glasumwandlungstemperatur (Tg) wird die Temperatur für die Mittelstufe bzw. den Wendepunkt angegeben.

Die relative Viskosität (ηrel) wurde gemäss DIN EN ISO 307 anhand von 0,5 Gew.-%-igen m-Kresollösungen bei 20 °C gemessen. Als Probe wird Granulat verwendet.

### Laserstrukturierung:

Zur Beurteilung des Metallisierungsverhaltens wurden spritzgegossene Formteile in VB3 und B11 (Platte 60 x 60 x 2 mm bzw. bei Beispiel B11 die hinterspritzte Folie B7 in gleicher Dimension 60 x 60 x 2 mm) sowie Folienausschnitte der Dimension 60x60x0.1 mm für die Beispiele B1 bis B10 mit Hilfe eines Nd:YAG-Lasers strukturiert und nachfolgend stromlos im Verkupferungsbad metallisiert. Bei der Laserstrukturierung wurden auf der Formteiloberfläche 32 nebeneinanderliegende, 4 x 4 mm grosse Bereiche bestrahlt. Die Laserstrukturierung erfolgte mittels eines Trumpf TruMark Station 5000 Lasers bei einer Wellenlänge von 1064 nm. Dabei wurden die Geschwindigkeit im Bereich von 300 bis 7200 mm/s, die Pulsfrequenz im Bereich von 10 - 80 kHz und der Hatch (Überlappung der Pulse) im Bereich von 0.03 bis 0.09 mm variiert (Fig. 1). Im Anschluss an die Laserstrukturierung werden die Formteile einem Reinigungsprozess zur Entfernung der Rückstände des Laserprozesses unterworfen. Die Formteile durchlaufen dabei nacheinander Ultraschallbäder mit Tensid und deionisiertem Wasser. Die gereinigten Formteile werden sodann nacheinander in reduktiven Verkupferungsbäder (MID Copper 100 XB Strike und MID Copper 100 XB Build, Mac Dermid) bei 55 bis 65°C metallisiert. Dabei beträgt die Aufenthaltszeit im Strike-Bad 20 min und im Build-Bad 1-3 h. Die Kupferabscheidungsrate (Dicke der Kupferschicht) im MID Copper 100 XB Build Bad auf den vom Laser bestrahlten Flächen beträgt durchschnittlich 3 bis 5 µm/h.

### Metallisierbarkeit:

Der Metallisierbarkeit wurde als der Quotient aus metallisierten Feldern zur Gesamtzahl der Felder berechnet und als prozentualer Anteil angegeben. Insgesamt werden pro Probenplatte 32 Felder mit unterschiedlichen Parametern, wie in Fig.1 gezeigt, mit dem Laser strukturiert und nachfolgend wie oben beschrieben metallisiert. Metallisierte Felder sind nur solche Felder, die in oben beschriebenen Prozess vollständig und gleichmässig metallisiert wurden.

Die chemisch-reduktive Kupferabscheidung ist bei allen MID-Technologien der entscheidende Startmetallisierungsprozess, der über die Qualität der Gesamtschicht entscheidet. Deshalb ist es völlig ausreichend, die Qualität der Primärmetallschicht zu beurteilen. Um zum fertigen MID-Teil zu kommen, werden aufbauend auf der ersten Kupferschicht (Primärschicht) in der Regel Nickel und anschliessend eine Endschicht aus Tauchgold abgeschieden. Selbstverständlich können auch andere Metallschichten, wie z.B. weitere Kupfer-, Palladium-, Zinn- oder Silberschichten auf die Primärschicht aufgebracht werden.

### Planarität:

Die Beurteilung der Folien bezüglich ihrer Planarität erfolgte visuell anhand von Folienausschnitten der Dimension 60 x 60 x 0.1 mm oder 150 x 150 x 0.1 mm, wie sie für die Laserstrukturierung eingesetzt wurden, und zwar jeweils nach der Folienherstellung, nach der Laserstrukturierung und nach der Metallisierung. Die Folienplanarität wird wie folgt charakterisiert:
+: Folie liegt plan auf einer glatten Oberfläche auf und weist in der Folienebene an keiner Stelle sichtbare Erhöhungen oder Tiefen auf, d.h. die Folie ist plan.
o: Folie liegt nicht plan auf einer glatten Oberfläche auf und weist in der Folienebene eindeutig mehrere Erhöhungen oder Tiefen auf, die ein Mehrfaches der Foliendicke ausmachen; die Folie ist insgesamt oder im Bereich, der mit dem Laser behandelt wurde, wellig.
-: Folie ist stark gewellt oder deutlich dreidimensional verformt

### Zusammenfassung Ergebnisse:

Die für B1 bis B10 aufgeführten Zusammensetzungen (Tabellen 2a und b) lassen sich problemlos durch Extrusion zu glatten, stippenlosen Folien mit einer Dicke von 100 Mikrometer verarbeiten. Die an ISO-Formkörpern bestimmten mechanischen Eigenschaften zeigen, dass diese Formmassen eine hohe Reissdehnung sowie hohe Schlagzähigkeit und eine gute Reissfestigkeit aufweisen. Die Folien lassen sich alle gut bis sehr gut strukturieren und metallisieren, ohne dass die dünnen Folien geschädigt werden. Weiterhin wurde festgestellt, dass die auf die Folien stromlos aufgebrachte Metallschicht auch eine sehr gute Haftung zum Folienmaterial besitzt. So lassen sich die metallisierten Folien mehrfach zu einer Rolle mit einem Durchmesser (d) kleiner gleich 10 mm aufrollen, ohne dass eine Ablösung oder optisch sichtbare Schädigung der Metallschicht beobachtet werden konnte. Die Folien in den Versuchen B5, B7 sowie B8-B10 behalten zudem ihre Planarität auch nach der Laserstrukturierung und der Metallisierung, während sich andere Folien, insbesondere jene von VB1 und VB2, bereits bei der Laserstrukturierung, aber spätestens bei der Metallisierung verziehen und wellig werden und damit ihre plane Gestalt völlig verlieren.

Tabelle 3 beinhaltet den Vergleich zwischen einem im Spritzguss hergestellten Formkörper, der das LDS-Additiv durchgehend enthält (VB3) und einem Formkörper gleicher Dimension, hergestellt durch Hinterspritzen der Folie B7 (Beispiel B11), der das LDS-Additiv in einer dünnen 100 Mikrometer dicken Schicht an einer Oberfläche enthält. Die Schicht gebildet aus dem hinterspritzten Kunststoff ist frei von LDS-Additiven. Die hinterspritzte Folie haftet sehr gut und vollflächig auf dem hinterspritzten Kunststoff, so dass eine zerstörungsfreie Ablösung der Folienschicht nicht möglich ist. Das durch Hinterspritzen hergestellte Formteil weist deutlich bessere mechanische Eigenschaften auf. So ist bei dem erfindungsgemässen Beispiel B11 bei höherem E-Modul die Reissfestigkeit um 35%, die Reissdehnung um 40%, die Schlagzähigkeit um 90% und die Kerbschlagzähigkeit um mehr als 100% gegenüber VB3 erhöht, und dies bei gleich guter Metallisierbarkeit des Formteils. Ein weiterer Vorteil von B11 ist der viel niedrigere LDS-Additiv-Bedarf für die Herstellung von solchen laserstrukturierbaren Formteilen. Bezogen auf das Formteil insgesamt ist bei B11 viel weniger LDS-Additiv erforderlich, nämlich nur 1/20 der der LDS-Additiv-Menge von VB3, um die gleich gute Metallisierbarkeit des Formteils zu erreichen.

## Patentansprüche

1. Verfahren zur Herstellung eines laserstrukturierbaren Bauteils, **dadurch gekennzeichnet, dass** ein extrudiertes, ein- oder mehrschichtiges Formteil mit mindestens einer, eine freiliegende Oberfläche des Formteils bildenden laserstrukturierbaren Schicht auf ein nicht laserstrukturierbares Trägerelement oberflächlich aufgebracht wird, oder mit einem nicht laserstrukturierbaren thermoplastischen Trägerelement hinterspritzt wird, so dass wenigstens eine laserstrukturierbare Schicht des Formteils wenigstens einen Teil der Oberfläche des laserstrukturierbaren Bauteils bildet, oder dass das extrudierte, ein- oder mehrschichtige Formteil zum Bauteil tiefgezogen wird, vorzugsweise ohne bereits Leiterbahnen vorgebildet zu haben,
wobei die laserstrukturierbare Schicht des Formteils im wesentlichen vollflächig besteht aus einer thermoplastischen Formmasse aus:
(A) 30 - 99.9 Gew.-% thermoplastischem Kunststoff bestehend aus Polyamid (A1), wobei (A1) besteht aus
einem cycloaliphatischen amorphen Polyamid (A1_4); oder
aus einer Mischung aus aliphatischen Polyamiden (A1_1) und teilaromatischen, teilkristallinen Polyamiden (A1_2), amorphen teilaromatischen Polyamiden (A1_3) und/oder amorphen cycloaliphatischen Polyamiden (A1_4);
oder aus einer Mischung aus einem Polyamid (A1) und einem anderen thermoplastischen Kunststoff (A2),
wobei der Anteil an Polyamid (A1) wenigstens 70 Gew.-% bezogen auf die Summe aus (A1) und (A2) ausmacht
und wobei (A1) besteht aus
einem teilaromatischen amorphen Polyamid (A1_3);
einem cycloaliphatischen amorphen Polyamid (A1_4); oder
aus einer Mischung aus aliphatischen Polyamiden (A1_1) und teilaromatischen, teilkristallinen Polyamiden (A1_2), amorphen teilaromatischen Polyamiden (A1_3) und/oder amorphen cycloaliphatischen Polyamiden (A1_4);
(B) 0.1 - 10 Gew.-% LDS-Additiv
(C) 0 - 60 Gew.-% Zuschlagsstoffe verschieden von (A) und (B);
wobei die Summe aus (A) - (C) 100 Gew.-% ausmacht.

2. Verfahren nach Anspruch 1, **dadurch gekennzeichnet, dass** die wenigstens eine laserstrukturierbare Schicht des Formteils ohne bereits Leiterbahnen vorgebildet zu haben ausgebildet ist respektive das extrudierte, ein- oder mehrschichtige Formteil zum Bauteil tiefgezogen wird ohne bereits Leiterbahnen vorgebildet zu haben.

3. Verfahren nach einem der vorhergehenden Ansprüche, **dadurch gekennzeichnet, dass** es sich beim Formteil um ein Profil, ein Rohr, einen Film oder eine Folie handelt, vorzugsweise um einen Film oder eine Folie, wobei vorzugsweise die laserstrukturierbare Schicht von Film respektive Folie vorzugsweise eine Dicke im Bereich von 10 - 1000 Micrometer, vorzugsweise im Bereich von 20 - 600 Micrometer, oder 30 - 400 Micrometer, oder 40 - 300 Micrometer aufweist und wobei weiterhin vorzugsweise der Film respektive die Folie durch die laserstrukturierbare Schicht allein gebildet wird oder eine oder mehrere von der laserstrukturierbaren Schicht verschiedene Trägerschichten aufweist, auf denen Film respektive Folie auf einer oder beiden Seiten, die Oberfläche bildend, angeordnet sind.

4. Verfahren nach einem der vorhergehenden Ansprüche, **dadurch gekennzeichnet, dass** das Formteil auf die Oberfläche des Trägerelements aufgeklebt, auflaminiert, oder aufkaschiert wird, jeweils vorzugsweise unter Anwendung von Druck und/oder Hitze;
oder dass das Formteil direkt aus dem schmelzflüssigen Zustand auf das Trägerelement in einer Coextrusion oder Mehrschichtextrusion aufextrudiert wird, vorzugsweise unter Verwendung einer Schlitzdüse in Form eines zusammenhängenden Films auf der Oberfläche des Trägerelements;
oder dass das Formteil als Folie in einer Form vorgelegt wird und durch das Trägerelement hinterspritzt wird.

5. Verfahren nach einem der vorhergehenden Ansprüche, **dadurch gekennzeichnet, dass** das Trägerelement und/oder insbesondere das Formteil aus einem polyamidhaltigen Kunststoff bestehen, in Form einer Mischung aus einem Polyamid (A1) und einem anderen thermoplastischen Kunststoff (A2), wobei der Anteil an Polyamid (A1) wenigstens 70 Gew.-% oder 80 Gew.-%, oder 100% bezogen auf die Summe aus (A1) und (A2) ausmacht,
wobei bevorzugt der Gehalt von Komponente (A1_1), bezogen auf die Summe aus der Komponenten (A1_1), (A1_2), (A1_3) und (A1_4), im Bereich von 40 bis 95 Gew.-% liegt,
und/oder wobei die Komponente (A1_1) ausgewählt ist aus der Gruppe bestehend aus: Polyamid PA610, PA106, PA1010, PA1012, PA 1212, PA11, PA12, oder Mischungen oder Copolyamide davon;
und/oder die Komponente (A1_2) ausgewählt ist aus der Gruppe bestehend aus: PA 4T/4I, PA 4T/6I, PA 5T/5I, PA 6T/6, PA 6T/6I, PA 6T/6I/6, PA 6T/66, 6T/610, 6T/612, PA 6T/10T, PA 6T/10I, PA 9T, PA 10T, PA 12T, PA 10T/10I, PA10T/106, PA10T/12, PA10T/11, PA 6T/9T, PA 6T/12T, PA 6T/10T/6I, PA 6T/6I/6, PA 6T/6I/12 sowie Mischungen oder Copolyamide davon; und/oder die Komponente (A1_3) ausgewählt ist aus der Gruppe bestehend aus:
6I/6T, 10I/10T, 12/6T, MXD6/MXDI sowie Mischungen oder Copolyamide davon, wobei bevorzugt 6I/6T, 10I/10T und 12/6T mit einem Anteil von weniger als 50 Mol-% 6T-Einheiten eingesetzt sind;
und/oder die Komponente (A1_4) ausgewählt ist aus der Gruppe bestehend aus: Polyamid PA MACM12, PA MACMI/12, PA MACMT/MACMI/12, MACM9, MACM10, MACM14, MACM16, MACM18, PACM12, PACM14, PACM16, PACM18, MACM12/PACM12, MACM14/PACM14, MACM16/PACM16, MACM18/PACM18, PACM9-18, 6I/6T/MACMI/MACMT/12, 6I/MACMI/MACMT, 6I/PACMI/PACMT, 6I/6T/MACMI, MACMI/MACM36, 12/PACMI oder 12/MACMT, 6I/PACMT, 6/IPDT, BACI/BACT, MACM12/BAC12, 10I/10T/BACI/BACT oder Mischungen oder Copolyamide davon.

6. Verfahren nach einem der vorhergehenden Ansprüche, **dadurch gekennzeichnet, dass**, wobei der Anteil an amorphem cycloaliphatischem Polyamid (A1_4) im Bereich von 20-100 Gew.-%, insbesondere vorzugsweise im Bereich von 30-90 oder 35-80 Gew.-% liegt, und der Anteil an aliphatischem Polyamid (A1_1) im Bereich von 0-80 Gew.-%, vorzugsweise im Bereich von 10-70 oder 20-65 Gew.-%.

7. Verfahren nach einem der vorhergehenden Ansprüche, **dadurch gekennzeichnet, dass** das Polyamid (A1) aufgebaut ist aus einem der Systeme ausgewählt aus der folgenden Gruppe: aliphatisches Polyamid (A1_1), teilaromatisches, teilkristallines Polyamid (A1_2), teilaromatisches amorphes Polyamid (A1_3), cycloaliphatisches amorphes Polyamid (A1_4), oder einer Mischung solcher Systeme, wobei das Polyamid (A1_4) aufgebaut ist aus 60 bis 100 mol-%, insbesondere 80 bis 100 mol-% mindestens einer aliphatischen und/oder aromatischer Dicarbonsäure mit 6 bis 14 oder 6 - 12 Kohlenstoffatomen sowie 0 bis 40 mol-%, insbesondere 0 bis 20 mol-% mindestens einer cycloaliphatischen Dicarbonsäure mit 8 bis 20 Kohlenstoffatomen, bezogen auf die Gesamtmenge der Dicarbonsäuren;
b) 50 bis 100 mol-%, bevorzugt 70 bis 100 mol-%, besonders bevorzugt 85 bis 100 mol-% mindestens eines cycloaliphatischen Diamins, vorzugsweise mit 6 bis 20 Kohlenstoffatomen, einschliesslich PACM, MACM, EACM, TMDC, BAC und IPD sowie 0 bis 50 mol-%, bevorzugt 0 - 30 mol-%, besonders bevorzugt 0 - 15 mol-% mindestens eines aliphatischen Diamins, mit 4-18 Kohlenstoffatomen, vorzugsweise mit 6 bis 12 Kohlenstoffatomen, bezogen auf die Gesamtmenge der Diamine, sowie gegebenenfalls;
c) Aminocarbonsäuren und/oder Lactamen je mit 6 bis 12 Kohlenstoffatomen; gebildet sind.

8. Verfahren nach einem der vorhergehenden Ansprüche, **dadurch gekennzeichnet, dass** das Polyamid (A1) zu
20 - 100 Gew.-%, bevorzugt 30-90 oder 35-80 Gew.-% aus amorphem cycloaliphatischem Polyamid (A1_4) und zu
0 - 80 Gew.-%, bevorzugt 10-70 oder 20-65 Gew.-% aus aliphatischem Polyamid (A1_1) und/oder teilkristallinem, teilaromatischem Polyamid (A1_2) besteht.

9. Verfahren nach einem der vorhergehenden Ansprüche, **dadurch gekennzeichnet, dass** in einem nachfolgenden Bearbeitungsschritt auf dem Bauteil durch Laser-Direktstrukturierung und anschließende stromlose Abscheidung Leiterbahnen auf dem Bauteil ausgebildet werden, sowie gegebenenfalls anschließend elektrische und/oder elektronische Komponenten eingebunden werden.

10. Bauteil hergestellt nach einem Verfahren gemäß einem der vorhergehenden Ansprüche, mit, auf einem nicht laserstrukturierbaren Trägerelement, einem extrudierten, ein- oder mehrschichtigen Formteil mit mindestens einer, eine freiliegende Oberfläche des Formteils bildenden laserstrukturierbaren Schicht vorbereitet für oder mit elektrischen Leiterbahnen,
wobei die laserstrukturierbare Schicht im wesentlichen vollflächig besteht aus einer thermoplastischen Formmasse aus:
(A) 30 - 99.9 Gew.-% thermoplastischem Kunststoff bestehend aus Polyamid (A1) wobei (A1) besteht aus
einem cycloaliphatischen amorphen Polyamid (A1_4); oder
aus einer Mischung aus aliphatischen Polyamiden (A1_1) und teilaromatischen, teilkristallinen Polyamiden (A1_2), amorphen teilaromatischen Polyamiden (A1_3) und/oder amorphen cycloaliphatischen Polyamiden (A1_4);
oder aus einer Mischung aus einem Polyamid (A1) und einem anderen thermoplastischen Kunststoff (A2),
wobei der Anteil an Polyamid (A1) wenigstens 70 Gew.-% bezogen auf die Summe aus (A1) und (A2) ausmacht und
wobei (A1) besteht aus
einem teilaromatischen amorphen Polyamid (A1_3);
einem cycloaliphatischen amorphen Polyamid (A1_4); oder
aus einer Mischung aus aliphatischen Polyamiden (A1_1) und teilaromatischen, teilkristallinen Polyamiden (A1_2), amorphen teilaromatischen Polyamiden (A1_3) und/oder amorphen cycloaliphatischen Polyamiden (A1_4)
;
(B) 0.1 - 10 Gew.-% LDS-Additiv
(C) 0 - 60 Gew.-% Zuschlagsstoffe verschieden von (A) und (B);
wobei die Summe aus (A) - (C) 100 Gew.-% ausmacht,, bevorzugt als Trägerelement, Leiterplatte, Gehäuse oder Gehäuseteil für insbesondere tragbare elektronische Geräte, wie insbesondere PDAs, Mobiltelefone, Telekommunikations-Geräte, Trägerelemente, Leiterplatten, Gehäuse oder Gehäuseteile für Personal Computer, Notebooks, medizinische Geräte, wie insbesondere Hörgeräte, Sensortechnik, oder RFID Transponder oder Teile für den Automobilbereich, wie insbesondere Airbagmodul, Multifunktionslenkrad.

11. Extrudiertes, ein- oder mehrschichtiges Formteil, vorzugsweise zur Verwendung in einem Verfahren gemäß einem der Ansprüche 1-11, mit mindestens einer, eine freiliegende Oberfläche des Formteils bildenden laserstrukturierbaren Schicht, im wesentlichen vollflächig bestehend aus einer thermoplastischen Formmasse aus:
(A) 30 - 99.9 Gew.-% thermoplastischem Kunststoff bestehend aus Polyamid (A1) wobei (A1) besteht aus
einem cycloaliphatischen amorphen Polyamid (A1_4); oder
aus einer Mischung aus aliphatischen Polyamiden (A1_1) und teilaromatischen, teilkristallinen Polyamiden (A1_2), amorphen teilaromatischen Polyamiden (A1_3) und/oder amorphen cycloaliphatischen Polyamiden (A1_4);
oder aus einer Mischung aus einem Polyamid (A1) und einem anderen thermoplastischen Kunststoff (A2),
wobei der Anteil an Polyamid (A1) wenigstens 70 Gew.-% bezogen auf die Summe aus (A1) und (A2) ausmacht, und
wobei (A1) besteht aus
einem teilaromatischen amorphen Polyamid (A1_3);
einem cycloaliphatischen amorphen Polyamid (A1_4); oder
aus einer Mischung aus aliphatischen Polyamiden (A1_1) und teilaromatischen, teilkristallinen Polyamiden (A1_2), amorphen teilaromatischen Polyamiden (A1_3) und/oder amorphen cycloaliphatischen Polyamiden (A1_4);
(B) 0.1 - 10 Gew.-% LDS-Additiv
(C) 0 - 60 Gew.-% Zuschlagsstoffe verschieden von (A) und (B);
wobei die Summe aus (A) - (C) 100 Gew.-% ausmacht,
wobei das Formteil ohne bereits Leiterbahnen vorgebildet zu haben ausgebildet ist oder bereits Leiterbahnen oder deren Vorläuferstrukturen vorgebildet hat, und wobei es sich beim Formteil um einen Film oder eine Folie mit einer Dicke im Bereich von 10 - 600 Micrometer handelt.

12. Formteil nach Anspruch 11, **dadurch gekennzeichnet, dass** der Film respektive die Folie eine Dicke im Bereich von20 - 600 Micrometer oder 30 - 400 Micrometer oder 40 - 300 Micrometer aufweist und wobei weiterhin vorzugsweise der Film respektive die Folie durch die laserstrukturierbare Schicht allein gebildet wird oder eine oder mehrere von der laserstrukturierbaren Schicht verschiedene Trägerschichten aufweist, auf denen Film respektive Folie auf einer oder beiden Seiten, die Oberfläche bildend, angeordnet sind, wobei dann vorzugsweise diese laserstrukturierbaren Oberflächenschichten auf Trägerschicht eine Dicke im Bereich von 10-100 µm, besonders bevorzugt von 10-50 µm.

13. Formteil nach einem der vorhergehenden Ansprüche 11-12, **dadurch gekennzeichnet, dass** der thermoplastische Kunststoff der Komponente (A) wenigstens ein aliphatisches Polyamid in einer Konzentration von mindestens 40 Gew.-%, bevorzugt in einem Bereich von 50 - 95 Gew.-% in Bezug auf die Gesamtmenge an Komponente (A) enthält, und wobei weiterhin vorzugsweise das wenigstens eine aliphatische Polyamid der Komponente (A) ein CH₂/Amid-Verhältnis von ≥ 7 aufweist,
oder dass der thermoplastische Kunststoff der Komponente (A) aus einer Mischung aus einem Polyamid (A1) und einem anderen thermoplastischen Kunststoff (A2) besteht, wobei der Anteil an Polyamid (A1) wenigstens 80 Gew.-%, oder 100% bezogen auf die Summe aus (A1) und (A2) ausmacht,
wobei der Gehalt von Komponente (A1_1), bezogen auf die Summe aus der Komponenten (A1_1), (A1_2), (A1_3) und (A1_4), im Bereich von 40 bis 95 Gew.-% liegt,
oder wobei die Komponente (A1_1) ausgewählt ist aus der Gruppe bestehend aus: Polyamid PA610, PA106, PA1010, PA1012, PA 1212, PA11, PA12, oder Mischungen oder Copolyamide davon;
oder dass die Komponente (A1_2) ausgewählt ist aus der Gruppe bestehend aus: PA 4T/4I, PA 4T/6I, PA 5T/5I, PA 6T/6, PA 6T/6I, PA 6T/6I/6, PA 6T/66, 6T/610, 6T/612, PA 6T/10T, PA 6T/10I, PA 9T, PA 10T, PA 12T, PA 10T/10I, PA10T/106, PA10T/12, PA10T/11, PA 6T/9T, PA 6T/12T, PA 6T/10T/6I, PA 6T/6I/6, PA 6T/6I/12 sowie Mischungen oder Copolyamide davon;
oder die Komponente (A1_3) ausgewählt ist aus der Gruppe bestehend aus: 6I/6T, 10I/10T, 12/6T, MXD6/MXDI sowie Mischungen davon, wobei bevorzugt 6I/6T, 10I/10T und 12/6T mit einem Anteil von weniger als 50 Mol-% 6T-Einheiten eingesetzt sind;
oder dass die Komponente (A1_4) ausgewählt ist aus der Gruppe bestehend aus: Polyamid PA MACM12, PA MACMI/12, PA MACMT/MACMI/12 MACM9, MACM10, MACM14, MACM16, MACM18, PACM12, PACM14, PACM16, PACM18, MACM12/PACM12, MACM14/PACM14, MACM16/PACM16, MACM18/PACM18, PACM9-18, 6I/6T/MACMI/MACMT/12, 6I/MACMI/MACMT, 6I/PACMI/PACMT, 6I/6T/MACMI, MACMI/MACM36, 12/PACMI oder 12/MACMT, 6I/PACMT, 6/IPDT, BACI/BACT, MACM12/BAC12, 10I/10T/BACI/BACT sowie Mischungen oder Copolyamide davon,
oder dass das Polyamid (A1) zu
20 - 100 Gew.-%, bevorzugt 30-90 oder 35-80 Gew.-% aus amorphem cycloaliphatischem Polyamid (A1_4) und zu
0 - 80 Gew.-%, bevorzugt 10-70 oder 20-65 Gew.-% aus aliphatischem Polyamid (A1_1) und/oder teilkristallinem, teilaromatischem Polyamid (A1_2) besteht, oder dass der Anteil an amorphem cycloaliphatischem Polyamid (A1_4) im Bereich von 20-100 Gew.-%, insbesondere vorzugsweise im Bereich von 30-90 oder 35-80 Gew.-% liegt, und der Anteil an aliphatischem Polyamid (A1_1) im Bereich von 0-80 Gew.-%, vorzugsweise im Bereich von 10-70 oder 20-65 Gew.-%,
oder dass das Polyamid (A1_4) aufgebaut ist aus
60 bis 100 mol-%, insbesondere 80 bis 100 mol-% mindestens einer aliphatischen und/oder aromatischer Dicarbonsäure mit 6 bis 14 oder 6 - 12 Kohlenstoffatomen sowie 0 bis 40 mol-%, insbesondere 0 bis 20 mol-% mindestens einer cycloaliphatischen Dicarbonsäure mit 8 bis 20 Kohlenstoffatomen, bezogen auf die Gesamtmenge der Dicarbonsäuren;
b) 50 bis 100 mol-%, bevorzugt 70 bis 100 mol-%, besonders bevorzugt 85 bis 100 mol-% mindestens eines cycloaliphatischen Diamins, vorzugsweise mit 6 bis 20 Kohlenstoffatomen, einschliesslich PACM, MACM, EACM, TMDC, BAC und IPD sowie 0 bis 50 mol-%, bevorzugt 0 - 30 mol-%, besonders bevorzugt 0 - 15 mol-% mindestens eines aliphatischen Diamins, mit 4-18 Kohlenstoffatomen, vorzugsweise mit 6 bis 12 Kohlenstoffatomen, bezogen auf die Gesamtmenge der Diamine, sowie gegebenenfalls;
c) Aminocarbonsäuren und/oder Lactamen je mit 6 bis 12 Kohlenstoffatomen; gebildet sind.

14. Formteil nach einem der vorhergehenden Ansprüche 11-13, **dadurch gekennzeichnet, dass** der Anteil an Komponente (A) im Bereich von 42-99 Gew.-% liegt, vorzugsweise im Bereich von 44-98 Gew.-%;
und/oder dass der Anteil an Komponente (B) im Bereich von 0.5-8 Gew.-% liegt, vorzugsweise im Bereich von 1-6 Gew.-%
und/oder dass der Anteil an Komponente (C) im Bereich von 0.5-50 Gew.-% liegt, vorzugsweise im Bereich von 1-40 Gew.-%.

15. Formteil nach einem der vorhergehenden Ansprüche 11-14, **dadurch gekennzeichnet, dass** Komponente (B) mindestens ein LDS-Additiv enthält oder ganz gebildet wird durch ein LDS-Additiv ausgewählt aus der folgenden Gruppe:
Metalloxid, Metallphosphat, vorzugsweise basisches Metallphosphat und/oder Metallhydroxidphosphat,
und/oder dass Komponente (B) mindestens ein LDS-Additiv enthält oder ganz gebildet wird durch ein LDS-Additiv, das eine anorganische Verbindung auf Basis des Kupfers und/oder Zinns ist,
wobei vorzugsweise Komponente (B) mindestens ein LDS-Additiv enthält oder ganz gebildet wird durch ein LDS-Additiv ausgewählt aus der folgenden Gruppe: Zinnoxid; Metall- oder Metalloxid-dotiertes Zinnoxid; Antimon-dotiertes Zinnoxid; Metalloxidbeschichteter Glimmer; mit Antimon-dotiertem Zinnoxid beschichteter Glimmer; Mischung aus Zinnoxid und Antimonoxid und optional weiterer Metalloxide; Spinelle; Kupferchromoxid; Kupferoxid; Kupferhydroxid;
Kupferhydroxidphosphat; Kupferphosphat; basische Kupferphosphate; Kupfer-Zinn-Phosphat; basisches Kupfer-Zinn-Phosphat; Zinnphosphat; basisches Zinnphosphat; antimondotiertes Zinnoxid, bevorzugt in Kombination mit Glimmer; oder Mischungen und Kombinationen davon.

16. Verfahren zur Herstellung eines Formteils nach einem der Ansprüche 11-15 mit einem Schritt der Extrusion der mindestens einen, eine freiliegende Oberfläche des Formteils bildenden laserstrukturierbaren Schicht, gegebenenfalls in Coextrusion mit einer oder mehreren weiteren Trägermaterialschichten.

## Claims

1. Process for producing a laser-structurable component, **characterized in that** an extruded, single-layer or multilayer molding having at least one laser-structurable layer that forms an exposed surface of the molding is applied to the surface of a non-laser-structurable carrier element, or is in-mold-coated with a non-laser-structurable thermoplastic carrier element, so that at least one laser-structurable layer of the molding forms at least one part of the surface of the laser-structurable component, or that the extruded, single-layer or multilayer molding is thermoformed to form the component, preferably without having already formed conductor tracks,
the laser-structurable layer of the molding consisting substantially over its entire area of a thermoplastic molding composition composed of:
(A) 30 - 99.9 wt% of a thermoplastic consisting of polyamide (A1), wherein (A1) consists of
a cycloaliphatic amorphous polyamide (A1_4) or a mixture of aliphatic polyamides (A1_1) and semiaromatic, semicrystalline polyamides (A1_2), amorphous semiaromatic polyamides (A1_3) and/or amorphous cycloaliphatic polyamides (A1_4)
or of a mixture of a polyamide (A1) and another thermoplastic (A2),
the fraction of polyamide (A1) being at least 70 wt%, based on the sum of (A1) and (A2), and wherein (A1) consists of an amorphous semiaromatic polyamide (A1_3)
a amorphous cycloaliphatic polyamide (A1_4) or
mixture of aliphatic polyamides (A1_1) and semiaromatic, semicrystalline polyamides (A1_2), amorphous semiaromatic polyamides (A1_3) and/or amorphous cycloaliphatic polyamides (A1_4);
(B) 0.1 - 10 wt% of LDS additive;
(C) 0 - 60 wt% of adjuvants different from (A) and (B);
the sum of (A) - (C) making 100 wt%.

2. The process as claimed in claim 1, **characterized in that** the at least one laser-structurable layer of the molding is designed without having already formed conductor tracks, or the extruded, single-layer or multilayer molding is thermoformed to form the component without having already formed conductor tracks.

3. The process as claimed in either of the preceding claims, **characterized in that** the molding is a profile, a pipe, a film or a foil, preferably a film or a foil, with preferably the laser structurable layer of film or foil preferably having a thickness in the range of 10 - 1000 micrometers, preferably in the range of 20 - 600 micrometers, or 30 - 400 micrometers, or 40 - 300 micrometers, and the film or foil further preferably being formed by the laser-structurable layer alone, or having one or more carrier layers which are different from the laser-structurable layer and on which film or foil are disposed on one or both sides, forming the surface.

4. The process as claimed in any of the preceding claims, **characterized in that** the molding is adhered, laminated or lined onto the surface of the carrier element, in each case preferably with application of pressure and/or heat and/or **in that** the molding is extruded directly from the molten state in a Coextrusion of a multilayer extrusion onto the carrier element, preferably using a slot die, in the form of a coherent film on the surface of the carrier element
and/or **in that** the molding is introduced as a foil in a mold and is in-mold-coated by the carrier element.

5. The process as claimed in any of the preceding claims, **characterized in that** the carrier element and/or, in particular, the molding consist of a polyamide-containing plastic, as a mixture of a polyamide (A1) and another thermoplastic (A2), the fraction of polyamide (A1) being at least 70 wt% or 80 wt%, or 100% based on the sum of (A1) and (A2),
and preferably the amount of component (A1_1), based on the sum of the components (A1_1), (A1_2), (A1_3) and (A1-4), is in the range from 40 to 95 wt%,
and/or component (A1_1) is selected from the group consisting of the following: polyamide PA610, PA106, PA1010, PA1012, PA1212, PA11, PA12, or mixtures or copolyamides thereof;
and/or component (A1_2) is selected from the group consisting of the following: PA 4T/4I, PA 4T/6I, PA 5T/5I, PA 6T/6, PA 6T/6I, PA 6T/6I/6, PA 6T/66, 6T/610, 6T/612, PA 6T/10T, PA 6T/10I, PA 9T, PA 10T, PA 12T, PA 10T/10I, PA10T/106, PA10T/12, PA10T/11, PA 6T/9T, PA 6T/12T, PA 6T/10T/6I, PA 6T/6I/6, PA 6T/6I/12, and also mixtures or copolyamides thereof;
and/or component (A1_3) is selected from the group consisting of the following: 6I/6T, 10I/10T, 12/6T, MXD6/MXDI, and also mixtures or copolyamides thereof, preference being given to use of 6I/6T, 10I/10T and 12/6T with a fraction of less than 50 mol% of 6T units;
and/or component (A1_4) is selected from the group consisting of the following: polyamide PA MACM12, PA MACMI/12, PA MACMT/MACMI/12, MACM9, MACM10, MACM14, MACM16, MACM18, PACM12, PACM14, PACM16, PACM18, MACM12/PACM12, MACM14/PACM14, MACM16/PACM16, MACM18/PACM18, PACM9-18, 61/6T/MACMI/MACMT/12, 61/MACMI/MACMT, 61/PACMI/PACMT, 6I/6T/MACMI, MACMI/MACM36, 12/PACMI or 12/MACMT, 6I/PACMT, 6/IPDT, BACI/BACT, MACM12/BAC12, 10I/10T/BACI/BACT, or mixtures or copolyamides thereof.

6. The process as claimed in any of the preceding claims, **characterized in that** (the fraction of amorphous cycloaliphatic polyamide (A1_4) is in the range of 20-100 wt%, especially preferably in the range of 30-90 or 35-80 wt%, and the fraction of aliphatic polyamide (A1_1) is in the range of 0-80 wt%, preferably in the range of 10-70 or 20-65 wt%.

7. The process as claimed in any of the preceding claims, **characterized in that** the polyamide (A1) is constructed from one of the systems selected from the following group: aliphatic polyamide (A1_1), semiaromatic, semicrystalline polyamide (A1_2), semiaromatic amorphous polyamide (A1_3), cycloaliphatic amorphous polyamide (A1_4), or a mixture of such systems, the polyamide (A1_4) being constructed from
a) 60 to 100 mol%, more particularly 80 to 100 mol%, of at least one aliphatic and/or aromatic dicarboxylic acid having 6 to 14 or 6 - 12 carbon atoms, and also 0 to 40 mol%, more particularly 0 to 20 mol%, of at least one cycloaliphatic dicarboxylic acid having 8 to 20 carbon atoms, based on the total amount of the dicarboxylic acids;
b) 50 to 100 mol%, preferably 70 to 100 mol%, more preferably 85 to 100 mol% of at least one cycloaliphatic diamine, preferably having 6 to 20 carbon atoms, including PACM, MACM, EACM, TMDC, BAC and IPD, and also 0 to 50 mol%, preferably 0 - 30 mol%, more preferably 0 - 15 mol% of at least one aliphatic diamine, having 4-18 carbon atoms, preferably having 6 to 12 carbon atoms, based on the total amount of diamines, and also optionally;
c) aminocarboxylic acids and/or lactams each having 6 to 12 carbon atoms.

8. The process as claimed in any of the preceding claims, **characterized in that** the polyamide (A1) consists of
20 - 100 wt%, preferably 30-90 or 35-80 wt%, of amorphous cycloaliphatic polyamide (A1_4) and of 0 - 80 wt%, preferably 10-70 or 20-65 wt%, of aliphatic polyamide (A1_1) and/or semicrystalline, semiaromatic polyamide (A1_2).

9. The process as claimed in any of the preceding claims, **characterized in that** conductor tracks are formed on the component in one of the following operating steps on the component, by laser direct structuring and subsequent electroless deposition, and also, optionally, electrical and/or electronic components are subsequently incorporated.

10. A component produced by a process as claimed in any of the preceding claims, with, on a a non-laser-structurable carrier element, an extruded, single-layer or multilayer molding having at least one laser-structurable layer that forms an exposed surface of the molding,
the laser-structurable layer of the molding consisting substantially over its entire area of a thermoplastic molding composition composed of:
(A) 30 - 99.9 wt% of a thermoplastic consisting of polyamide (A1), wherein (A1) consists of a cycloaliphatic amorphous polyamide (A1_4) or a mixture of aliphatic polyamides (A1_1) and semiaromatic, semicrystalline polyamides (A1_2), amorphous semiaromatic polyamides (A1_3) and/or amorphous cycloaliphatic polyamides (A1_4) or of a mixture of a polyamide (A1) and another thermoplastic (A2), the fraction of polyamide (A1) being at least 70 wt%, based on the sum of (A1) and (A2), and wherein (A1) consists of
an amorphous semiaromatic polyamide (A1_3) a amorphous cycloaliphatic polyamide (A1_4) or
mixture of aliphatic polyamides (A1_1) and semiaromatic, semicrystalline polyamides (A1_2), amorphous semiaromatic polyamides (A1_3) and/or amorphous cycloaliphatic polyamides (A1_4);
(B) 0.1 - 10 wt% of LDS additive;
(C) 0 - 60 wt% of adjuvants different from (A) and (B);
the sum of (A) - (C) making 100 wt%, preferably as carrier element, circuit board, casing or casing part for electronic devices, more particularly portable electronic devices, such as especially PDAs, mobile telephones, telecommunications devices, carrier elements, circuit boards, casings or casing parts for personal computers, notebook computers, medical devices, such as especially hearing devices, sensor technology, or RFID transponders or parts for the automotive sector, such as especially airbag module, multi-function steering wheel.

11. An extruded single-layer or multilayer molding, preferably for use in a process as claimed in any of claims 1-11, having at least one laser-structurable layer which forms an exposed surface of the molding, consisting substantially over its entire area of a thermoplastic molding composition composed of:
(A) 30 - 99.9 wt% of thermoplastic consisting of polyamide (A1) wherein (A1) consists
of a cycloaliphatic amorphous polyamide (A1_4) or a mixture of aliphatic polyamides (A1_1) and semiaromatic, semicrystalline polyamides (A1_2), amorphous semiaromatic polyamides (A1_3) and/or amorphous cycloaliphatic polyamides (A1_4)
or of a mixture of a polyamide (A1) and another thermoplastic (A2), the fraction of polyamide (A1) being at least 70 wt%, based on the sum of (A1) and (A2) and wherein (A1) consists of an amorphous semiaromatic polyamide (A1_3) a amorphous cycloaliphatic polyamide (A1_4)
or
mixture of aliphatic polyamides (A1_1) and semiaromatic, semicrystalline polyamides (A1_2), amorphous semiaromatic polyamides (A1_3) and/or amorphous cycloaliphatic polyamides (A1_4);;
(B) 0.1 - 10 wt% of LDS additive;
(C) 0 - 60 wt% of adjuvants different from (A) and (B);
the sum of (A) - (C) making 100 wt% where the molded part is formed without having already formed conductive tracks or has already formed conductive tracks or their precursor structures, and
wherein the moulding is a film or sheet having a thickness in the range 10-600 micrometers.

12. The molding as claimed in claim 11, **characterized in that** the film or foil having a thickness in the range of 20 - 600 micrometers, or 30 - 400 micrometers, or 40 - 300 micrometers, and the film or foil further preferably being formed by the laser-structurable layer alone, or having one or more carrier layers which are different from the laser-structurable layer and on which film or foil are disposed on one or both sides, forming the surface, in which case then preferably these laser-structurable surface layers on carrier layer have a thickness in the range of 10-100 µm, more preferably of 10-50 µm.

13. The molding as claimed in either of preceding claims 11-12, **characterized in that** the thermoplastic of component (A) comprises at least one aliphatic polyamide in a concentration of at least 40 wt%, preferably in a range of 50 - 95 wt% in relation to the total amount of component (A), and where, furthermore, preferably the at least one aliphatic polyamide of component (A) has a CH₂/amide ratio of ≥ 7
or **in that** the thermoplastic of component (A) consists of a mixture of a polyamide (A1) and another thermoplastic (A2), where the fraction of polyamide (A1) is at least 80 wt%, or 100% based on the sum of (A1) and (A2),
and the amount of component (A1_1), based on the sum of the components (A1_1), (A1_2), (A1_3) and (A1_4), is in the range from 40 to 95 wt%,
or component (A1_1) is selected from the group consisting of the following: polyamide PA610, PA106, PA1010, PA1012, PA1212, PA11, PA12, or mixtures or copolyamides thereof;
or component (A1_2) is selected from the group consisting of the following: PA 4T/4I, PA 4T/6I, PA 5T/5I, PA 6T/6, PA 6T/6I, PA 6T/6I/6, PA 6T/66, 6T/610, 6T/612, PA 6T/10T, PA 6T/10I, PA 9T, PA 10T, PA 12T, PA 10T/10I, PA10T/106, PA10T/12, PA10T/11, PA 6T/9T, PA 6T/12T, PA 6T/10T/6I, PA 6T/6I/6, PA 6T/6I/12, and also mixtures or copolyamides thereof;
or component (A1_3) is selected from the group consisting of the following: 6I/6T, 10I/10T, 12/6T, MXD6/MXDI and also mixtures thereof, preference being given to use of 6I/6T, 10I/10T and 12/6T with a fraction of less than 50 mol% of 6T units;
or component (A1_4) is selected from the group consisting of the following: polyamide PA MACM12, PA MACMI/12, PA MACMT/MACMI/12, MACM9, MACM10, MACM14, MACM16, MACM18, PACM12, PACM14, PACM16, PACM18, MACM12/PACM12, MACM14/PACM14, MACM16/PACM16, MACM18/PACM18, PACM9-18, 61/6T/MACMI/MACMT/12, 61/MACMI/MACMT, 61/PACMI/PACMT, 6I/6T/MACMI, MACMI/MACM36, 12/PACMI or 12/MACMT, 61/PACMT, 6/IPDT, BACI/BACT, MACM12/BAC12, 10I/10T/BACI/BACT, or mixtures or copolyamides thereof
or **in that** the polyamide (A1) consists of 20 - 100 wt%, preferably 30-90 or 35-80 wt% of amorphous cycloaliphatic polyamide (A1_4) and of 0 - 80 wt%, preferably 10-70 or 20-65 wt%, of aliphatic polyamide (A1_1) and/or semicrystalline, semiaromatic polyamide (A1_2)
or **in that** the fraction of amorphous cycloaliphatic polyamide (A1_4) is in the range of 20-100 wt%, especially preferably in the range of 30-90 or 35-80 wt%, and the fraction of aliphatic polyamide (A1_1) is in the range of 0-80 wt%, preferably in the range of 10-70 or 20-65 wt% or **in that** the polyamide (A1_4) being constructed from
a) 60 to 100 mol%, more particularly 80 to 100 mol%, of at least one aliphatic and/or aromatic dicarboxylic acid having 6 to 14 or 6 - 12 carbon atoms, and also 0 to 40 mol%, more particularly 0 to 20 mol%, of at least one cycloaliphatic dicarboxylic acid having 8 to 20 carbon atoms, based on the total amount of the dicarboxylic acids;
b) 50 to 100 mol%, preferably 70 to 100 mol%, more preferably 85 to 100 mol% of at least one cycloaliphatic diamine, preferably having 6 to 20 carbon atoms, including PACM, MACM, EACM, TMDC, BAC and IPD, and also 0 to 50 mol%, preferably 0 - 30 mol%, more preferably 0 - 15 mol% of at least one aliphatic diamine, having 4-18 carbon atoms, preferably having 6 to 12 carbon atoms, based on the total amount of diamines, and also optionally;
c) aminocarboxylic acids and/or lactams each having 6 to 12 carbon atoms.

14. The molding as claimed in any of preceding claims 11-13, **characterized in that** the fraction of component (A) is in the range of 42-99 wt%, preferably in the range of 44-98 wt%;
and/or **in that** the fraction of component (B) is in the range of 0.5-8 wt%, preferably in the range of 1-6 wt%;
and/or **in that** the fraction of component (C) is in the range of 0.5-50 wt%, preferably in the range of 1-40 wt%.

15. The molding as claimed in any of preceding claims 11-14, **characterized in that** component (B) comprises at least one LDS additive or is entirely formed by an LDS additive selected from the following group:
metal oxide, metal phosphate, preferably basic metal phosphate and/or metal hydroxide phosphate,
and/or **in that** component (B) comprises at least one LDS additive or is entirely formed by an LDS additive which is an inorganic compound based on copper and/or tin,
and preferably component (B) comprises at least one LDS additive or is entirely formed by an LDS additive selected from the following group:
tin oxide; metal-doped or metal oxide-doped tin oxide; antimony-doped tin oxide; metal oxide-coated mica; mica coated with antimony-doped tin oxide; mixture of tin oxide and antimony oxide and
optionally further metal oxides; spinels; copper chromium oxide; copper oxide; copper hydroxide; copper hydroxide phosphate; copper phosphate; basic copper phosphate; copper tin phosphate; basic copper tin phosphate; tin phosphate; basic tin phosphate; antimony-doped tin oxide,
preferably in combination with mica; or mixtures and combinations thereof.

16. Process for producing molding according to any of claims 11-15, with a step of extruding the at least one laser-structurable layer which forms an exposed surface of the molding, optionally in coextrusion with one or more further carrier material layers.

## Revendications

1. Procédé de fabrication d'un composant structurable par laser, **caractérisé en ce qu'**une pièce moulée mono- ou multicouche extrudée comprenant au moins une couche structurable par laser formant une surface libre de la pièce moulée est appliquée en surface sur un élément support non structurable par laser, ou surmoulée avec un élément support thermoplastique non structurable par laser, de telle sorte qu'au moins une couche structurable par laser de la pièce moulée forme au moins une partie de la surface du composant structurable par laser, ou **en ce que** la pièce moulée mono- ou multicouche extrudée est emboutie pour former le composant, de préférence sans avoir déjà préformé des pistes conductrices,
la couche structurable par laser de la pièce moulée étant essentiellement constituée sur l'ensemble de sa surface par un matériau de moulage thermoplastique constitué par :
(A) 30 à 99,9 % en poids d'une matière plastique thermoplastique constituée par :
un polyamide (A1), (A1) étant constitué par :
un polyamide amorphe cycloaliphatique (A1_4) ;
ou
un mélange de polyamides aliphatiques (A1_1) et de polyamides partiellement aromatiques, partiellement cristallins (A1_2), de polyamides amorphes partiellement aromatiques (A1_3) et/ou de polyamides amorphes cycloaliphatiques (A1_4) ;
ou un mélange d'un polyamide (Al) et d'une autre matière plastique thermoplastique (A2),
la proportion de polyamide (Al) étant d'au moins 70 % en poids, par rapport à la somme de (Al) et (A2), et (Al) étant constitué par :
un polyamide amorphe partiellement aromatique (A1_3) ;
un polyamide amorphe cycloaliphatique (A1_4) ; ou
un mélange de polyamide aliphatiques (A1_1) et de polyamides partiellement aromatiques, partiellement cristallins (A1_2), de polyamides amorphes partiellement aromatiques (A1_3) et/ou de polyamides amorphes cycloaliphatiques (A1_4) ;
(B) 0,1 à 10 % en poids d'additif LDS,
(C) 0 à 60 % en poids d'additifs différents de (A) et (B) ;
la somme de (A) à (C) étant de 100 % en poids.

2. Procédé selon la revendication 1, **caractérisé en ce que** ladite au moins une couche structurable par laser de la pièce moulée est formée sans avoir déjà préformé des pistes conductrices ou la pièce moulée mono- ou multicouche extrudée est emboutie pour former le composant sans avoir déjà préformé des pistes conductrices.

3. Procédé selon l'une quelconque des revendications précédentes, **caractérisé en ce que** la pièce moulée est un profilé, un tube, un film ou une feuille, de préférence un film ou une feuille, la couche structurable par laser du film ou de la feuille présentant de préférence une épaisseur dans la plage allant de 10 à 1 000 micromètres, de préférence dans la plage allant de 20 à 600 micromètres, ou de 30 à 400 micromètres, ou de 40 à 300 micromètres, et le film ou la feuille étant par ailleurs de préférence formé uniquement par la couche structurable par laser, ou comprenant une ou plusieurs couches supports différentes de la couche structurable par laser, sur lesquelles le film ou la feuille est agencé sur un des ou les deux côtés formant la surface.

4. Procédé selon l'une quelconque des revendications précédentes, **caractérisé en ce que** la pièce moulée est collée, stratifiée ou contrecollée sur la surface de l'élément support, à chaque fois de préférence en utilisant de la pression et/ou de la chaleur ;
ou **en ce que** la pièce moulée est extrudée directement à partir de l'état fondu liquide sur l'élément support par une co-extrusion ou une extrusion de couches multiples, de préférence en utilisant une buse à fente sous la forme d'un film cohérent sur la surface de l'élément support ;
ou **en ce que** la pièce moulée est chargée sous la forme d'une feuille dans un moule et surmoulée par l'élément support.

5. Procédé selon l'une quelconque des revendications précédentes, **caractérisé en ce que** l'élément support et/ou notamment la pièce moulée sont constitués par une matière plastique contenant du polyamide, sous la forme d'un mélange d'un polyamide (Al) et d'une autre matière plastique thermoplastique (A2), la proportion de polyamide (Al) étant d'au moins 70 % en poids ou 80 % en poids ou 100 %, par rapport à la somme de (Al) et (A2),
la teneur du composant (A1_1), par rapport à la somme des composants (A1_1), (A1_2), (A1_3) et (A1_4), se situant de préférence dans la plage allant de 40 à 95 % en poids,
et/ou le composant (A1_1) étant choisi dans le groupe constitué par : le polyamide PA610, PA106, PA1010, PA1012, PA1212, PA11, PA12 ou leurs mélanges ou copolyamides ;
et/ou le composant (A1_2) étant choisi dans le groupe constitué par : PA 4T/4I, PA 4T/6I, PA 5T/5I, PA 6T/6, PA 6T/6I, PA 6T/6I/6, PA 6T/66, 6T/610, 6T/612, PA 6T/10T, PA 6T/10I, PA 9T, PA 10T, PA 12T, PA 10T/10I, PA10T/106, PA10T/12, PA10T/11, PA 6T/9T, PA 6T/12T, PA 6T/10T/6I, PA 6T/6I/6, PA 6T/6I/12, ainsi que leurs mélanges ou copolyamides ;
et/ou le composant (A1_3) étant choisi dans le groupe constitué par : 6I/6T, 10I/10T, 12/6T, MXD6/MXDI, ainsi que leurs mélanges ou copolyamides, de préférence 6I/6T, 10I/10T et 12/6T ayant une proportion inférieure à 50 % en moles d'unités 6T ;
et/ou le composant (A1_4) étant choisi dans le groupe constitué par: le polyamide PA MACM12, PA MACMI/12, PA MACMT/MACMI/12, MACM9, MACM10, MACM14, MACM16, MACM18, PACM12, PACM14, PACM16, PACM18, MACM12/PACM12, MACM14/PACM14, MACM16/PACM16, MACM18/PACM18, PACM9-18, 6I/6T/MACMI/MACMT/12, 61/MACMI/MACMT, 6I/PACMI/PACMT, 6I/6T/MACMI, MACMI/MACM36, 12/PACMI oder 12/MACMT, 6I/PACMT, 6/IPDT, BACI/BACT, MACM12/BAC12, 10I/10T/BACI/BACT ou leurs mélanges ou copolyamides.

6. Procédé selon l'une quelconque des revendications précédentes, **caractérisé en ce que** la proportion de polyamide amorphe cycloaliphatique (A1_4) se situe dans la plage allant de 20 à 100 % en poids, de manière particulièrement préférée dans la plage allant de 30 à 90 ou 35 à 80 % en poids, et la proportion de polyamide aliphatique (A1_1) se situe dans la plage allant de 0 à 80 % en poids, de préférence dans la plage allant de 10 à 70 ou 20 à 65 % en poids.

7. Procédé selon l'une quelconque des revendications précédentes, **caractérisé en ce que** le polyamide (Al) est formé par un système choisi dans le groupe suivant : un polyamide aliphatique (A1_1), un polyamide partiellement aromatique, partiellement cristallin (A1_2), un polyamide amorphe partiellement aromatique (A1_3), un polyamide amorphe cycloaliphatique (A1_4), ou un mélange de tels systèmes, le polyamide (A1_4) étant formé par : 60 à 100 % en moles, notamment 80 à 100 % en moles, d'au moins un acide dicarboxylique aliphatique et/ou aromatique contenant 6 à 14 ou 6 à 12 atomes de carbone, ainsi que 0 à 40 % en moles, notamment 0 à 20 % en moles, d'au moins un acide dicarboxylique cycloaliphatique contenant 8 à 20 atomes de carbone, par rapport à la quantité totale des acides dicarboxyliques ;
b) 50 à 100 % en moles, de préférence 70 à 100 % en moles, de manière particulièrement préférée 85 à 100 % en moles d'au moins une diamine cycloaliphatique, de préférence contenant 6 à 20 atomes de carbone, y compris PACM, MACM, EACM, TMDC, BAC et IPD, ainsi que 0 à 50 % en moles, de préférence 0 à 30 % en moles, de manière particulièrement préférée 0 à 15 % en moles d'au moins une diamine aliphatique, contenant 4 à 18 atomes de carbone, de préférence 6 à 12 atomes de carbone, par rapport à la quantité totale des diamines, ainsi qu'éventuellement
c) des acides aminocarboxyliques et/ou des lactames contenant chacun 6 à 12 atomes de carbone.

8. Procédé selon l'une quelconque des revendications précédentes, **caractérisé en ce que** le polyamide (A1) est constitué par :
20 à 100 % en poids, de préférence 30 à 90 ou 35 à 80 % en poids d'un polyamide cycloaliphatique amorphe (A1_4) et
0 à 80 % en poids, de préférence 10 à 70 ou 20 à 65 % en poids d'un polyamide aliphatique (A1_1) et/ou d'un polyamide partiellement cristallin, partiellement aromatique (A1_2).

9. Procédé selon l'une quelconque des revendications précédentes, **caractérisé en ce que**, lors d'une étape de traitement ultérieure sur le composant par structuration directe par laser, puis dépôt sans courant, des pistes conductrices sont formées sur le composant, puis des composants électriques et/ou électroniques sont éventuellement intégrés.

10. Composant fabriqué par un procédé selon l'une quelconque des revendications précédentes, comprenant, sur un élément support non structuralble par laser, une pièce moulée mono- ou multicouche extrudée comprenant au moins une couche structurable par laser formant une surface libre de la pièce moulée, préparée pour ou avec des pistes conductrices électriques,
la couche structurable par laser étant essentiellement constituée sur l'ensemble de sa surface par un matériau de moulage thermoplastique constitué par :
(A) 30 à 99,9 % en poids d'une matière plastique thermoplastique constituée par :
un polyamide (A1), (A1) étant constitué par :
un polyamide amorphe cycloaliphatique (A1_4) ; ou
un mélange de polyamides aliphatiques (A1_1) et de polyamides partiellement aromatiques, partiellement cristallins (A1_2), de polyamides amorphes partiellement aromatiques (A1_3) et/ou de polyamides amorphes cycloaliphatiques (A1_4) ;
ou un mélange d'un polyamide (Al) et d'une autre matière plastique thermoplastique (A2),
la proportion de polyamide (A1) étant d'au moins 70 % en poids, par rapport à la somme de (A1) et (A2), et (A1) étant constitué par :
un polyamide amorphe partiellement aromatique (A1_3) ;
un polyamide amorphe cycloaliphatique (A1_4) ; ou
un mélange de polyamide aliphatiques (A1_1) et de polyamides partiellement aromatiques, partiellement cristallins (A1_2), de polyamides amorphes partiellement aromatiques (A1_3) et/ou de polyamides amorphes cycloaliphatiques (A1_4) ;
(B) 0,1 à 10 % en poids d'additif LDS,
(C) 0 à 60 % en poids d'additifs différents de (A) et (B) ;
la somme de (A) à (C) étant de 100 % en poids,
de préférence en tant qu'élément support, plaque conductrice, boîtier ou partie de boîtier pour appareils électroniques, notamment portables, tels que notamment des PDA, des téléphones portables, des appareils de télécommunication, des éléments supports, des plaques conductrices, des boîtiers ou des parties de boîtiers pour ordinateurs personnels, notebooks, appareils médicaux, tels que notamment des appareils d'audition, pour la technologie des capteurs, ou des transpondeurs RFID ou des pièces pour le domaine automobile, telles que notamment un module d'airbag, un volant multifonction.

11. Pièce moulée mono- ou multicouche extrudée, de préférence destinée à être utilisée dans un procédé selon l'une quelconque des revendications 1 à 11, comprenant au moins une couche structurable par laser formant une surface libre de la pièce moulée, essentiellement constituée sur l'ensemble de sa surface par un matériau de moulage thermoplastique constitué par :
(A) 30 à 99,9 % en poids d'une matière plastique thermoplastique constituée par :
un polyamide (A1), (A1) étant constitué par :
un polyamide amorphe cycloaliphatique (A1_4) ; ou
un mélange de polyamides aliphatiques (A1_1) et de polyamides partiellement aromatiques, partiellement cristallins (A1_2), de polyamides amorphes partiellement aromatiques (A1_3) et/ou de polyamides amorphes cycloaliphatiques (A1_4) ;
ou un mélange d'un polyamide (A1) et d'une autre matière plastique thermoplastique (A2),
la proportion de polyamide (A1) étant d'au moins 70 % en poids, par rapport à la somme de (A1) et (A2),
et (Al) étant constitué par :
un polyamide amorphe partiellement aromatique (A1_3) ;
un polyamide amorphe cycloaliphatique (A1_4) ; ou
un mélange de polyamide aliphatiques (A1_1) et de polyamides partiellement aromatiques, partiellement cristallins (A1_2), de polyamides amorphes partiellement aromatiques (A1_3) et/ou de polyamides amorphes cycloaliphatiques (A1_4) ;
(B) 0,1 à 10 % en poids d'additif LDS,
(C) 0 à 60 % en poids d'additifs différents de (A) et (B) ;
la somme de (A) à (C) étant de 100 % en poids,
la pièce moulée étant formée sans avoir déjà préformé des pistes conductrices ou ayant déjà des pistes conductrices ou leurs structures précurseurs préformées, et
la pièce moulée étant un film ou une feuille d'une épaisseur dans la plage allant de 10 à 600 micromètres.

12. Pièce moulée selon la revendication 11, **caractérisée en ce que** le film ou la feuille présente une épaisseur dans la plage allant de 20 à 600 micromètres ou de 30 à 400 micromètres ou de 40 à 300 micromètres, et le film ou la feuille est par ailleurs de préférence formé uniquement par la couche structurable par laser, ou comprend une ou plusieurs couches supports différentes de la couche structurable par laser, sur lesquelles le film ou la feuille est agencé sur un des ou les deux côtés formant la surface, ces couches de surface structurables par laser sur la couche support présentant alors de préférence une épaisseur dans la plage allant de 10 à 100 µm, de manière particulièrement préférée de 10 à 50 µm.

13. Pièce moulée selon l'une quelconque des revendications 11 à 12 précédentes, **caractérisée en ce que** la matière plastique thermoplastique du composant (A) contient au moins un polyamide aliphatique en une concentration d'au moins 40 % en poids, de préférence dans une plage allant de 50 à 95 % en poids, par rapport à la quantité totale de composant (A), ledit au moins un polyamide aliphatique du composant (A) présentant par ailleurs de préférence un rapport CH₂/amide ≥ 7,
ou **en ce que** la matière plastique thermoplastique du composant (A) est constituée par un mélange d'un polyamide (Al) et d'une autre matière plastique thermoplastique (A2), la proportion de polyamide (Al) étant d'au moins 80 % en poids ou 100 %, par rapport à la somme de (Al) et (A2),
la teneur du composant (A1_1), par rapport à la somme des composants (A1_1), (A1_2), (A1_3) et (A1_4), se situant dans la plage allant de 40 à 95 % en poids,
ou le composant (A1_1) étant choisi dans le groupe constitué par : le polyamide PA610, PA106, PA1010, PA1012, PA1212, PA11, PA12 ou leurs mélanges ou copolyamides ;
ou le composant (A1_2) étant choisi dans le groupe constitué par : PA 4T/4I, PA 4T/6I, PA 5T/5I, PA 6T/6, PA 6T/6I, PA 6T/6I/6, PA 6T/66, 6T/610, 6T/612, PA 6T/10T, PA 6T/10I, PA 9T, PA 10T, PA 12T, PA 10T/10I, PA10T/106, PA10T/12, PA10T/11, PA 6T/9T, PA 6T/12T, PA 6T/10T/6I, PA 6T/6I/6, PA 6T/6I/12, ainsi que leurs mélanges ou copolyamides ;
ou le composant (A1_3) étant choisi dans le groupe constitué par : 6I/6T, 10I/10T, 12/6T, MXD6/MXDI, ainsi que leurs mélanges ou copolyamides, de préférence 6I/6T, 10I/10T et 12/6T ayant une proportion inférieure à 50 % en moles d'unités 6T ;
ou le composant (A1_4) étant choisi dans le groupe constitué par: le polyamide PA MACM12, PA MACMI/12, PA MACMT/MACMI/12, MACM9, MACM10, MACM14, MACM16, MACM18, PACM12, PACM14, PACM16, PACM18, MACM12/PACM12, MACM14/PACM14, MACM16/PACM16, MACM18/PACM18, PACM9-18, 6I/6T/MACMI/MACMT/12, 61/MACMI/MACMT, 6I/PACMI/PACMT, 6I/6T/MACMI, MACMI/MACM36, 12/PACMI ou 12/MACMT, 6I/PACMT, 6/IPDT, BACI/BACT, MACM12/BAC12, 10I/10T/BACI/BACT, ainsi que leurs mélanges ou copolyamides,
ou **en ce que** le polyamide (Al) est constitué par 20 à 100 % en poids, de préférence 30 à 90 ou 35 à 80 % en poids d'un polyamide cycloaliphatique amorhe (A1_4)
et 0 à 80 % en poids, de préférence 10 à 70 ou 20 à 65 % en poids d'un polyamide aliphatique (A1_1) et/ou d'un polyamide partiellement cristallin, partiellement aromatique (A1_2),
ou **en ce que** la proportion de polyamide amorphe cycloaliphatique (A1_4) se situe dans la plage allant de 20 à 100 % en poids, de manière particulièrement préférée dans la plage allant de 30 à 90 % en poids ou 35 à 80 % en poids, et la proportion de polyamide aliphatique (A1_1) se situe dans la plage allant de 0 à 80 % en poids, de préférence dans la plage allant de 10 à 70 ou 20 à 65 % en poids,
ou **en ce que** le polyamide (A1_4) est formé par : 60 à 100 % en moles, notamment 80 à 100 % en moles, d'au moins un acide dicarboxylique aliphatique et/ou aromatique contenant 6 à 14 ou 6 à 12 atomes de carbone, ainsi que 0 à 40 % en moles, notamment 0 à 20 % en moles, d'au moins un acide dicarboxylique cycloaliphatique contenant 8 à 20 atomes de carbone, par rapport à la quantité totale des acides dicarboxyliques ;
b) 50 à 100 % en moles, de préférence 70 à 100 % en moles, de manière particulièrement préférée 85 à 100 % en moles d'au moins une diamine cycloaliphatique, de préférence contenant 6 à 20 atomes de carbone, y compris PACM, MACM, EACM, TMDC, BAC et IPD, ainsi que 0 à 50 % en moles, de préférence 0 à 30 % en moles, de manière particulièrement préférée 0 à 15 % en moles d'au moins une diamine aliphatique, contenant 4 à 18 atomes de carbone, de préférence 6 à 12 atomes de carbone, par rapport à la quantité totale des diamines, ainsi qu'éventuellement
c) des acides aminocarboxyliques et/ou des lactames contenant chacun 6 à 12 atomes de carbone.

14. Pièce moulée selon l'une quelconque des revendications 11 à 13 précédentes, **caractérisée en ce que** la proportion du composant (A) se situe dans la plage allant de 42 à 99 % en poids, de préférence dans la plage allant de 44 à 98 % en poids ;
et/ou **en ce que** la proportion du composant (B) se situe dans la plage allant de 0,5 à 8 % en poids, de préférence dans la plage allant de 1 à 6 % en poids ; et/ou **en ce que** la proportion du composant (C) se situe dans la plage allant de 0,5 à 50 % en poids, de préférence dans la plage allant de 1 à 40 % en poids.

15. Pièce moulée selon l'une quelconque des revendications 11 à 14 précédentes, **caractérisée en ce que** le composant (B) contient au moins un additif LDS ou est formé en totalité par un additif LDS choisi dans le groupe suivant : un oxyde de métal, un phosphate de métal, de préférence un phosphate de métal basique et/ou un hydroxyphosphate de métal,
et/ou **en ce que** le composant (B) contient au moins un additif LDS ou est formé en totalité par un additif LDS, qui est un composé inorganique à base de cuivre et/ou d'étain,
le composant (B) contenant de préférence au moins un additif LDS ou étant formé en totalité par un additif LDS choisi dans le groupe suivant : l'oxyde d'étain ; l'oxyde d'étain dopé par un métal ou un oxyde de métal ; l'oxyde d'étain dopé par de l'antimoine ; le mica revêtu par un oxyde de métal ; le mica revêtu avec de l'oxyde d'étain dopé par de l'antimoine ; un mélange d'oxyde d'étain et d'oxyde d'antimoine et éventuellement d'autres oxydes de métaux ; les spinelles ; l'oxyde de cuivre et de chrome ; l'oxyde de cuivre ; l'hydroxyde de cuivre ; l'hydroxyphosphate de cuivre ; le phosphate de cuivre ; le phosphate de cuivre basique ; le phosphate de cuivre et d'étain ; le phosphate de cuivre et d'étain basique ; le phosphate d'étain ; le phosphate d'étain basique ; l'oxyde d'étain dopé par de l'antimoine, de préférence en combinaison avec du mica ; ou leurs mélanges et combinaisons.

16. Procédé de fabrication d'une pièce moulée selon l'une quelconque des revendications 11 à 15, comprenant une étape d'extrusion de ladite au moins une couche structurable par laser formant une surface libre de la pièce moulée, éventuellement par co-extrusion avec une ou plusieurs couches de matériau support supplémentaires.
